# EUROPEAN PATENT APPLICATION

(11) **EP 4 361 671 A1**
(43) Date of publication of application: **01.05.2024**
(21) Application number: 22827006.2
(22) Date of filing: 21.02.2022
(51) Int. Cl.: G01S 7/4863, G01S 7/4861

(54) **LIGHT DETECTION CIRCUIT AND METHOD, LASER RADAR AND STORAGE MEDIUM, AND DETECTION SYSTEM**

(30) Priority: 22.06.2021 CN 202110693340; 13.08.2021 CN 202110931016
(71) Applicant: Hesai Technology Co., Ltd., Shanghai 201821 (CN)
(72) Inventor: CHEN, Zhengtao, Shanghai 201821 (CN); ZHU, Xuezhou, Shanghai 201821 (CN); XIANG, Shaoqing, Shanghai 201821 (CN)
(74) Representative: Fish & Richardson P.C.
(86) International application number: PCT/CN2022/077012
(87) International publication number: WO 2022/267497

(57) **Abstract**

A light detection circuit, comprising: an array of photodetector units (301), which comprises a plurality of photodetector units (311) that are configured to receive light signals and generate corresponding electrical signals; an array of switches (302), which comprises a plurality of first switch units (321), each first switch unit (321) being correspondingly coupled to a photodetector unit (311), and each first switch unit (321) being configured to control the operating state of the coupled photodetector unit (311), such that a signal output terminal of the coupled photodetector unit (311) outputs an electrical signal; and a selector unit, which is configured to select the photodetector unit (311) in the operating state to output electrical signals. By setting the switch states of the first switch units (321) respectively, photodetector units (311) that are required to operate are selected to be activated for operation, and photodetector units (311) that are not required to operate are set as being unable to be activated, preventing a measurement channel of a LiDAR from being affected by crosstalk caused by external interference light, improving detection accuracy, and also preventing unnecessary energy consumption. Further provided are a method, a LiDAR and a storage medium, and a detection system. In addition, this disclosure also relates to a light detection method, a LiDAR and a storage medium, and a pulse signal peak detection system.

## Description

### CROSS REFERENCE TO RELATED APPLICATIONS

This patent application claims priority to Chinese Patent Application No. 202110693340.7, filed on June 22, 2021, and titled "Light Detection Circuit, Light Detection Method, LiDAR and Storage Medium", and also claims priority to Chinese Patent Application No. 202110931016.4, filed on August 13, 2021, and titled "Pulse Signal Peak Detection System and LiDAR", which are incorporated herein by reference in their entirety.

### TECHNICAL FIELD

This disclosure relates to the field of optical ranging, and in particular to a light detection circuit and method, a LiDAR and storage medium, and a detection system.

### BACKGROUND

A LiDAR is a device that detects the outside by emitting laser and detecting an echo signal returned when the laser arrives at the surface of an obstacle.

With the improvement of the precision and resolution of LiDARs, the multi-detection-channel has become the mainstream development trend. For example, for LiDARs with 32, 64, and 128 lines, each "line" refers to one detection channel. A detection channel includes at least one laser that operates together in the LiDAR to emit laser and at least one photodetector that detects an echo signal of the laser.

The operating principle of a photodetector is explained below in an example.

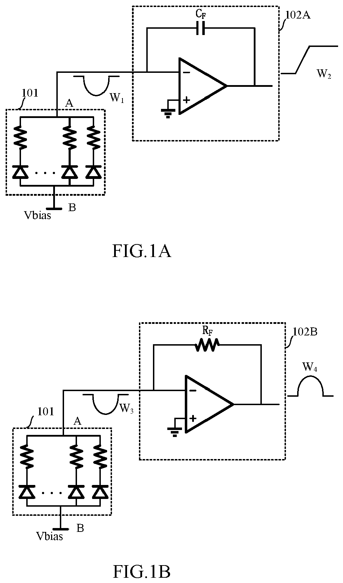

In FIG. 1A, a structural schematic diagram of a connection between a photodetector and a voltage amplifier in an example is shown.

FIG. 1A shows that a photodetector 101 can be a silicon photomultiplier (SiPM) as an example. The SiPM includes connecting a plurality of single photon avalanche diodes (SPADs) and matched quenching resistors in parallel, the SPADs are avalanche photon diodes (APDs) operating in a Geiger mode. When a reverse bias voltage higher than the breakdown voltage Vₜₕ of a SPAD is applied to both terminals (A and B terminals shown in the diagram) of a SiPM, each SPAD is in the Geiger mode (GM) and can detect a light signal. The diagram shows an example that a bias voltage V_{bias} connected to the B terminal, the voltage at the A terminal is set to be V_{A}, and the V_{bias} is set to satisfy V_{A}-V_{bias}>Vₜₕ, the V_{A}-V_{bias} represents the reverse bias voltage that can activate the SiPM.

The voltage amplifier shown in FIG. 1A is implemented as a charge sensitive amplifier (CSA) 102A. The CSA circuit includes: an operational amplifier; and a capacitor C_{F} that spans between a negative input terminal and an output terminal of the operational amplifier. The negative input terminal of the operational amplifier is further coupled to the A terminal of the photodetector 101, and a positive input terminal of the operational amplifier is coupled to the ground terminal. The current signal output by the photodetector 101 passes through and charges the capacitor C_{F}, and is converted into a voltage signal and outputted. The conversion speed of the CSA is relatively slow; further, referring to the difference between a waveform W1 of the current signal and a waveform D of the converted voltage signal, it can be seen that the CSA cannot restore the waveform of the current signal in its converted voltage signal.

In FIG. 1B, a structural schematic diagram of a connection between a photodetector and a voltage amplifier as another example is shown.

Comparing the embodiment of FIG. 1A and FIG. 1B, the main difference lies in that the voltage amplifier in FIG.1B is implemented as a trans-impedance amplifier (TIA) 102B. The TIA includes: an operational amplifier; and a resistor R_{F} that spans between a negative input terminal and an output terminal of the operational amplifier. The TIA converts a current signal output by the photodetector 101 into a voltage signal through the resistor R_{F}, and the relationship between the current signal and the voltage signal is a linear relationship of U=I*R_{F}. Therefore, it can be seen that by a waveform comparison between a current signal waveform W1 and a voltage signal waveform W2, the waveform W2 preserves the pulse frequency and width information of the waveform W1.

With the improvement of the precision and resolution of the LiDAR, the LiDAR typically can detect light signal detection in a plurality of detection channels by a photodetector 101 array, for example, by linear-array or area-array of photodetectors, each array of photodetectors includes a plurality of photodetectors. Respective photodetectors 101 in the photodetector 101 array can be allocated to different detection channels as demanded, and at least one photodetector 101 in the same detection channel can be activated to operate together. Due to the increasing number (e.g., 32, 64, 128, or the like) of detection channels, to acquire detection results of detection signals in respective detection channels concurrently, it is needed to arrange signal processing circuits respectively corresponding to respective detection channels, and this is difficult to implement in practical engineering applications. Hence, a multiplexer (MUX) typically can be used to select a detection signal of the photodetector 101 in a detection channel, and a detection result of this channel can be obtained through time division processing with a shared signal processing circuit.

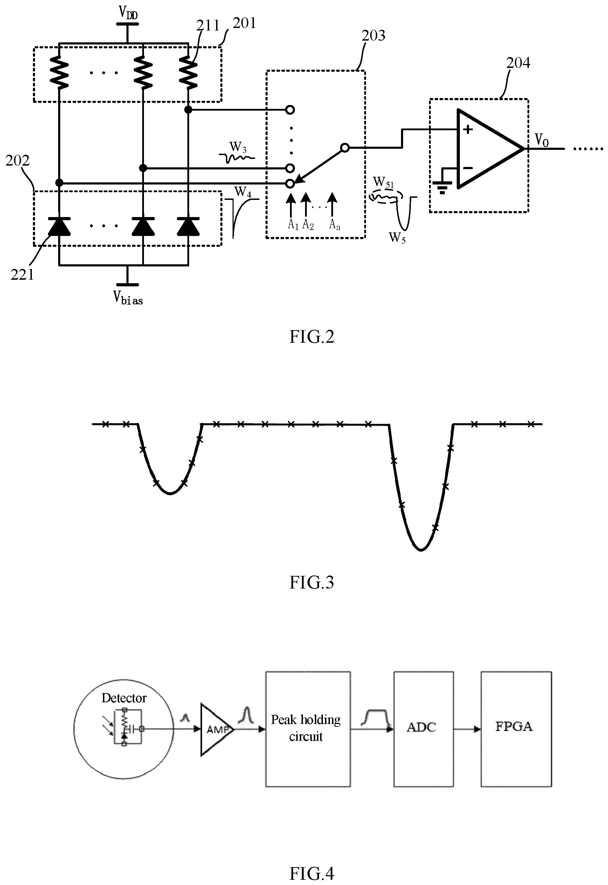

In FIG. 2, a schematic diagram of a partial structure of a light detection circuit of an array of photodetectors in an example is shown.

In this example, the photodetectors arrays 202 includes a plurality of photodetectors 221 (e.g., SiPM) and a resistor array 201. Respective photodetectors 221 are respectively located in different branches connected in parallel, and each resistor 211 in the resistor array 201 is correspondingly connected in series with a photodetector 221 in a branch. Each branch is connected to a voltage V_{DD} as a reverse bias voltage applied to the array of photodetectors 202 to activate respective photodetectors 221 therein to operate. The output terminal of a photodetector 221 in each branch is coupled to one input terminal of the multiplexer 203.

For example, supposing that there are n detection channels, each detection channel corresponds to one photodetector 221 for detecting an echo signal into the detection channel, for converting the echo signal into an electrical signal (e.g., a voltage signal). Further, output terminals of photodetectors 221 in different detection channels can be selected respectively through selection signals of A₁~Aₙ, to be connected to output terminals of the multiplexer 203, to output an electrical signal in a selected detection channel, convert the electrical signal into a voltage Vₒ by the voltage amplifier 204 and output the voltage. The voltage amplifier 204 can be implemented as, for example, the CSA in the example of FIG. 1A, or the TIA in the example of FIG. 1B. The voltage Vₒ can be input to a back-stage circuit for processing to obtain a detection result in the selected detection channel.

However, there are many problems with the light detection circuit in FIG. 2.

To make the following expressed in a clearer manner, the detection channel selected to operate is defined below as a "measurement channel", and a detection channel not selected to operate is defined as a "non-measurement channel". As shown in FIG. 2, each photodetector 221 is always in an operating state, and although the multiplexer 203 has selected the electrical signal of the measurement channel to be outputted, the photodetectors 221 belonging to the non-measurement channels still detect light signals, convert the detected light signals into electrical signals and transmit the electrical signals to the input terminals of the multiplexer 203. In one aspect, the photodetectors 221 of the non-measurement channels are always in the operating state, clearly resulting in unnecessary large power consumption; in a further aspect, due to the inevitable parasitic capacitance of the multiplexer 203, electrical signals output by the photodetectors 221 of the non-measurement channels are interference signals, which causes crosstalk to the electrical signal in the measurement channel through the parasitic capacitance of the multiplexer 203 (see the interference signal waveform W₃ in FIG. 2), leading to burrs (e.g., the W₅₁ in the waveform W₅ of the output signal), pulse broadening, or the like. After the electrical signal (see the echo signal waveform W4 in the diagram) of the echo signal in the measurement channel passes through the multiplexer 203. Especially when the photodetector 221 is a SiPM, due to its high gain, the SiPM has a stronger capability to detect weak light, making the generated interference more obvious. In another aspect, V_{DD} is set for photodetectors 221 corresponding to a fixed operating voltage and cannot be adapted to photodetectors 221 with different operating voltages.

As can be seen from FIG. 2, during detection, only photodetectors in a limited number of channels are activated together to be in a detecting state, while other photodetectors in the non-measurement channels are in a waiting state. The photodetectors in the waiting state still can detect light signals, and external interference (e.g., external ambient light) can be detected by the photodetectors in the waiting state, which form interference with the measurement channels in the normal detecting state, thereby affecting detection results. Further, respective photodetectors in the waiting state can also generate a large amount of unnecessary power waste.

Additionally, in applications such as a LiDAR receiver, a signal received by the light detection circuit is typically a pulse signal with an extremely narrow pulse width (e.g., a typical value of about 2-6ns), and the duty cycle of the signal is very low, that is, there is no signal coming most of the time. To achieve higher ranging precision and other performance, peak information of a pulse signal is needed to be acquired. Typically, a high-speed analog to digital converter (ADC) is utilized to perform full-waveform sampling of a pulse signal detected by the light detection circuit, a typical sampling rate of the high-speed ADC being not less than 1GHz. Supposing that the ADC sampling rate is 1GHz, that is, correspondingly, one data point is collected at 1ns, as shown in FIG. 3. For a pulse with a pulse width of 5ns, 5 data can be collected, while for a pulse with a pulse width of 2ns, only 2 data can be collected, making it difficult to form an effective waveform.

Due to the high cost and large power consumption of the high-speed ADC, and the very low duty cycle of the corresponding echo pulse signal, there is only a small number of useful signals among the signals output by the high-speed ADC, causing more waste in resources and power consumption, and limiting the application of the system. For this purpose, a solution of sampling a pulse signal utilizing a peak holding circuit and a medium to low-speed ADC has been proposed in the existing technology.

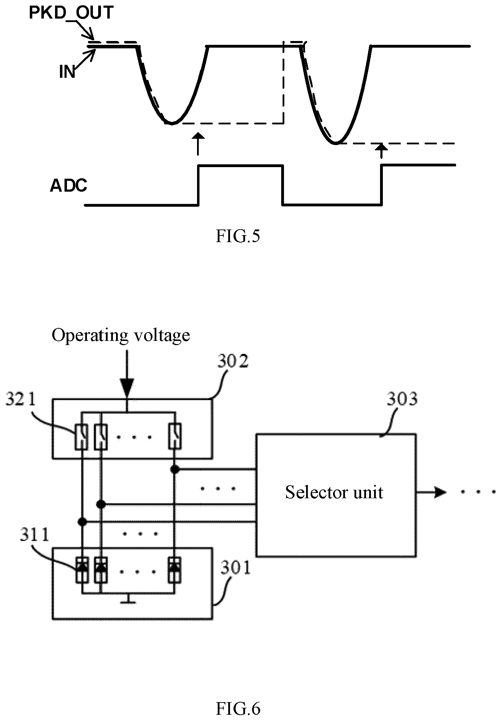

Referring to FIG. 4, a circuit schematic diagram of sampling an echo pulse signal utilizing a peak holding circuit and a medium to low-speed ADC is shown. A detector (i.e., the aforesaid light detection circuit) detects a pulse signal, which is amplified through an amplifier (AMP). Among others, the detector can be a SiPM (silicon photomultiplier) and the amplifier can be a TIA (trans-impedance amplifier). The peak voltage of the amplified pulse signal is held through a peak holding circuit, and the signal output by the peak holding circuit is sampled by an ADC, as shown in FIG. 5, to obtain the peak data of the pulse. The ADC inputs the sampled data into a FPGA (field-programmable gate array), and the FPGA processes the sampled data. Although this way of sampling can meet some application demands, when there is a plurality of echo pulse signals relatively close, the medium to low-speed ADC (e.g., with a sampling rate of 1MHz) cannot be directly utilized to perform peak sampling on two echo pulse signals, leading to a decrease in the sampling accuracy.

### SUMMARY

In view of the aforesaid drawbacks in the existing technology, this disclosure provides a light detection circuit and method, a LiDAR and a storage medium, and a detection system, which can prevent a measurement channel of a LiDAR from being affected by crosstalk caused by external interference light, improve detection accuracy, and also avoid unnecessary energy consumption.

To achieve the above objectives and other relevant objectives, the first aspect of this disclosure provides a light detection circuit for a LiDAR, including: an array of photodetector units including a plurality of photodetector units for receiving light signals and generating corresponding electrical signals; an array of switches including a plurality of first switch units, each first switch unit being correspondingly coupled to a photodetector unit, and each first switch unit being configured to control an operating state of the coupled photodetector unit, such that a signal output terminal of the coupled photodetector unit outputs the electrical signal; and a selector unit configured to select a photodetector unit in the operating state to output the electrical signal.

According to some embodiments in the first aspect, the light detection circuit includes: a first power supply terminal coupled to a power supply source; the first switch unit including: a first switching element with one terminal coupled to the first power supply terminal, and the other terminal coupled to one terminal of a photodetector unit; the one terminal of the photodetector unit coupled to the first switching element being a signal output terminal; wherein a switch state of the first switching element corresponds to ON/OFF of a path between the first power supply terminal and the signal output terminal.

According to some embodiments in the first aspect, each of the first switch units further includes: a second switching element with one terminal coupled to one terminal of the photodetector unit coupled to the first switching element, and the other terminal coupled to a ground terminal; wherein a switch state of the second switching element corresponds to ON/OFF of a path between the signal output terminal and the ground terminal.

According to some embodiments in the first aspect, switch states of the first switching element and the second switching element are set to be opposite.

According to some embodiments in the first aspect, the light detection circuit includes a power supply regulator unit with an output terminal connected to the first power supply terminal to provide a variable power supply.

According to some embodiments in the first aspect, the power supply source is regulated to output multiple voltage values; and the plurality of voltage values are respectively adapted to photodetector units with different operating voltages.

According to some embodiments in the first aspect, the light detection circuit includes a level shifter unit with an input terminal coupled to an output terminal of the selector unit, and configured to convert a voltage output by the selector unit to a predetermined voltage range.

According to some embodiments in the first aspect, the level shifter unit includes at least one second switch unit, a first impedance unit, and a current source; each second switch unit including a first terminal coupled to the first power supply terminal, a second terminal coupled to one terminal of the first impedance unit, and a control terminal coupled to the output terminal of the selector unit; and the control terminal is configured to controlling ON/OFF of the first terminal and the second terminal; and the other terminal of the first impedance unit is coupled to one terminal of the current source, and the other terminal of the current source is coupled to the ground terminal.

According to some embodiments in the first aspect, the current source includes: a first current mirror circuit including a first branch and a second branch respectively led out by at least one pair of common-gate transistors, with the gate coupled to the control terminal of the current source; a second impedance unit being connected in series in the first branch; one terminal of each of the first branch and the second branch being coupled to the second power supply terminal, and the other terminal of the first branch being grounded through the second impedance unit; and voltages connected to the second power supply terminal and the first power supply terminal being different; and a second current mirror circuit including a third branch and a fourth branch respectively led out by at least one pair of common-gate transistors; one terminal of the third branch being coupled in series to the other terminal of the second branch, and the other terminal of the third branch being coupled to the ground terminal; one terminal of the fourth branch being coupled to one terminal of the first impedance unit, and the other terminal of the fourth branch being grounded, such that a ratio value between currents flowing through the first impedance unit and the second impedance unit is regulatable.

According to some embodiments in the first aspect, the fourth branch includes N sub-branches in parallel, with the N greater than or equal to 2, a transistor being connected in series in each sub-branch, wherein the transistor of each sub-branch can be selected to be connected to or disconnected from a transistor in the third branch, to regulate the ratio value between the currents flowing through the first impedance unit and the second impedance unit.

According to some embodiments in the first aspect, the current source includes: a first current mirror circuit including at least one first PMOS and at least one second PMOS connected through a common gate and a common source, the gate being coupled to the control terminal of the current source, and the source being connected to the second power supply terminal; a drain of the first PMOS is coupled to the ground terminal through the second impedance unit; wherein voltages connected to the second power supply terminal and the first power supply terminal are different; and a second current mirror circuit including: a first NMOS with a gate and a drain that are coupled to a drain of the second PMOS, and a source coupled to the ground terminal; and at least one second NMOS connected with the first NMOS through a common gate, and with a drain coupled to one terminal of the first impedance unit and a source coupled to the ground terminal.

According to some embodiments in the first aspect, there are N second NMOSs, with the N greater than or equal to 2; each second MOS has a drain coupled to one another and coupled to one terminal of the first impedance unit, and a source coupled to the ground terminal; and each second NMOS has a gate coupled to the gate of the first NMOS through a third switching element, and coupled to the ground terminal through a fourth switching element.

According to some embodiments in the first aspect, the current source further includes: an operational amplifier including: a negative input terminal connected to a reference voltage; a positive input terminal coupled to one terminal of the second impedance unit to apply the reference voltage; and an output terminal used as the control terminal of the current source.

According to some embodiments in the first aspect, the second switch unit includes a third NMOS; and the control terminal, the first terminal, and the second terminal of the second switch unit are respectively led out by a gate, a drain, and a source of the third NMOS.

According to some embodiments in the first aspect, the first impedance unit includes one of the following: a variable resistor or a plurality of transistors connected in series.

According to some embodiments in the first aspect, there is a plurality of the second switch units connected in parallel.

According to some embodiments in the first aspect, the light detection circuit includes: an integral operator unit coupled to the output terminal of the level shifter unit for performing an integral operation according to a received electrical signal to obtain an operation result; and an analog-to-digital converter unit coupled to an output terminal of the integral operator unit for performing analog-to-digital conversion according to the operation result.

According to some embodiments in the first aspect, the first switch unit further includes a variable impedance unit connected in series between a first switching element and a photodetector unit.

According to some embodiments in the first aspect, the light detection circuit includes: a first power supply terminal coupled to a power supply source; the first switch unit further including: a trans-impedance amplifier unit including a first input terminal coupled with the first switching element to the first power supply terminal, and coupled with the second switching element to the ground terminal; a second input terminal coupled to one terminal of a photodetector unit, and coupled to an output terminal of the trans-impedance amplifier unit through a third impedance unit; and the output terminal coupled to the signal output terminal.

To achieve the above objectives and other relevant objectives, the second aspect of this disclosure provides a light detection method, which is applied to control the light detection circuit according to any one of the first aspect, and the light detection method including: transmitting switch signals to the array of switches to set switch states of some of first switch units to drive photodetector units coupled to the some of first switch units to activate to detect light signals; and to set switch states of the rest of first switch units to deactivate photodetector units coupled to the rest of first switch units.

According to some embodiments in the second aspect, applying switch signals to the some of first switch units in the array of switches to drive the coupled photodetector units to activate includes: applying switch signals to respective first switch units in a part of the array of switches one by one to drive respective photodetector units to activate correspondingly.

To achieve the above objectives and other relevant objectives, the third aspect of this disclosure provides a LiDAR, including: a light emitter module including an array of light emitter units configured to output an emitted signal; a light detector module including a light detection circuit according to any one of the first aspect; wherein an array of photodetector units is configured to receive an echo signal reflected after the emitted signal collides with an obstacle; and a controller module coupled with the light emitter module and the light detector module, and configured to transmit switch signals to the array of switches to set switch states of some of first switch units to drive photodetector units coupled to the some of first switch units to activate to detect light signals; and to set switch states of the rest of first switch units to deactivate photodetector units coupled to the rest of first switch units.

To achieve the above objectives and other relevant objectives, the fourth aspect of this disclosure provides a computer-readable storage medium storing program instructions that execute the light detection method according to any one of the second aspect when being run.

To achieve the above objectives and other relevant objectives, the fifth aspect of this disclosure provides a pulse signal peak detection system, the system includes: a peak detection circuit for receiving a pulse signal to be detected, detecting peak signals of the pulse signal, and outputting the peak signals to a multi-channel sampling and holding circuit; the multi-channel sampling and holding circuit for sampling and storing respective peak signals of the pulse signal to be detected respectively; and an analog-to-digital conversion circuit for sampling respective peak signals stored in the multi-channel sampling and holding circuit one by one, and outputting sampled data corresponding to the pulse signal to be detected. The sampling accuracy of the pulse sampling system based on a medium to low-speed ADC, and the adaptability of the system can be improved.

According to some embodiments in the fifth aspect, the number of multi-channel sampling and holding circuits is set based on a pulse frequency of the pulse signal to be detected and a conversion frequency of the analog-to-digital converter.

According to some embodiments in the fifth aspect, the system further includes a first comparator and a clock generator,
the first comparator with two input terminals, into which a pulse signal to be detected and an output signal of the peak detection circuit are respectively input, to convert the pulse signal to be detected into a digital pulse signal and output the digital pulse signal to the clock generator; and
the clock generator generating a first control signal based on the digital pulse signal output by the first comparator; and the first control signal being configured to controlling a sampling time sequence of the multi-channel sampling and holding circuit.

According to some embodiments in the fifth aspect, when the pulse signal to be detected is a negative pulse signal, and when the pulse signal to be detected is greater than the output signal of the peak detection circuit, the clock generator outputs the first control signal; and the first control signal is configured to controlling the multi-channel sampling and holding circuit to sample and store each peak signal in the pulse signal to be detected.

According to some embodiments in the fifth aspect, when the pulse signal to be detected is a positive pulse signal, and when the pulse signal to be detected is smaller than the output signal of the peak detection circuit, the clock generator outputs the first control signal; and the first control signal is configured to controlling the multi-channel sampling and holding circuit to sample and store each peak signal in the pulse signal to be detected.

According to some embodiments in the fifth aspect, the clock generator further generates a second control signal based on the digital pulse signal output by the first comparator, the second control signal being a reset signal for the peak detection circuit.

According to some embodiments in the fifth aspect, after the multi-channel sampling and holding circuit samples and stores one of peak signals in the pulse signal to be detected, the second control signal resets the peak detection circuit, such that the peak detection circuit redetects the next peak signal in the pulse signal to be detected.

According to some embodiments in the fifth aspect, each sampling and holding circuit in the multi-channel sampling and holding circuit includes a sampling switch, an operational amplifier, and a capacitor, the sampling switch being connected to the output terminal of the peak detection circuit and a positive input terminal of the operational amplifier, the capacitor being connected to the positive input terminal of the operational amplifier and the ground, a negative input terminal of the operational amplifier being connected to an output terminal of the operational amplifier, and the sampling switch being controlled by the first control signal.

According to some embodiments in the fifth aspect, the clock generator further generates a third control signal based on the digital pulse signal output by the first comparator; and the analog-to-digital conversion circuit includes a multiplexer and an analog-to-digital converter connected to an output terminal of the multiplexer; and
the multiplexer gates, based on the third control signal, respective sampling and holding circuits in the multi-channel sampling and holding circuit one by one for sampling by the analog-to-digital converter.

According to some embodiments in the fifth aspect, after the first control signal controls one of the sampling and holding circuits in the multi-channel sampling and holding circuit to carry out storage, the multiplexer gates the one of the sampling and holding circuits based on the third control signal to cause the analog-to-digital converter to carry out sampling.

According to some embodiments in the fifth aspect, the multiplexer includes a plurality of control switches, each control switch being connected to an output terminal of one sampling and holding circuit and an input terminal of the analog-to-digital converter.

According to some embodiments in the fifth aspect, the analog-to-digital conversion circuit includes a plurality of analog-to-digital converters, each analog-to-digital converter with an input terminal connected to an output terminal of one sampling and holding circuits in the multi-channel sampling and holding circuit.

According to some embodiments in the fifth aspect, the analog-to-digital converter includes a second comparator, a logic circuit, and a digital to analog converter,
the second comparator with one input terminal connected to the output terminal of the multiplexer, the other input terminal connected to an output terminal of the digital to analog converter, and an output terminal connected to an input terminal of the logic circuit; and
the logic circuit with an output terminal outputting sampled data of the pulse signal to be detected, and outputting a feedback signal to the digital to analog converter.

To achieve the above objectives and other relevant objectives, the sixth aspect of this disclosure provides a LiDAR, the LiDAR includes an emitter unit, a receiver unit, and a pulse signal peak detection system described above, the emitter unit being configured to emit a detection beam for detecting a target object; the receiver unit being configured to receive an echo beam of the detection beam reflected on the target object, and convert the echo beam into an echo pulse signal; and the pulse signal peak detection system being used to sample the echo pulse signal and output the sampled signal. The sampling accuracy of the received signal of the LiDAR can be improved and the hardware cost can be reduced.

In summary, this disclosure provides a light detection circuit and method, a LiDAR and a storage medium, and a detection system. Among others, the light detection circuit includes an array of photodetector units including a plurality of photodetector units for receiving light signals and generating corresponding electrical signals; an array of switches including a plurality of first switch units, each first switch unit being correspondingly coupled to a photodetector unit, and each first switch unit being configured to control an operating state of the coupled photodetector unit, such that a signal output terminal of the coupled photodetector unit outputs the electrical signal; and a selector unit configured to select a photodetector unit in the operating state to output the electrical signal. By setting the switch states of the first switch units respectively, photodetector units that are required to operate together are selected to be activated to operate, and photodetector units that are not required to operate are set to be unable to be activated, which can prevent a measurement channel of a LiDAR from being affected by crosstalk caused by external interference light, improve detection accuracy, and also prevent unnecessary energy consumption.

In addition, in a pulse signal peak detection system, with regard to the problems existing in the current process of sampling a high-speed pulse signal utilizing a peak holding and sampling circuit and a medium to low-speed ADC, a multi-channel sampling and holding circuit is added on the basis of the structures of the peak holding and sampling circuit and ADC circuit. Respective sampling and holding circuits in the multi-channel sampling and holding circuit sequentially samples and stores peak signals of a plurality of echo pulse signals respectively; further, by gating the stored peak signals one by one for sampling by the ADC, it can also achieve sampling of respective peak signals even in the case that time intervals of a plurality of echo pulse signals in the pulse signal to be detected are relatively close, effectively improving the accuracy of echo pulse signal sampling.

### BRIEF DESCRIPTION OF THE DRAWINGS

FIG. 1A shows a structural schematic diagram of a connection between a photodetector and a voltage amplifier in an example;
FIG. 1B shows a structural schematic diagram of a connection between a photodetector and a voltage amplifier in another example;
FIG. 2 shows a schematic diagram of a partial structure of a detection circuit of an array of photodetectors in an example;
FIG. 3 shows a schematic diagram of utilizing a high-speed ADC for full waveform sampling of echo pulse signals in an example;
FIG. 4 shows a circuit schematic diagram of sampling an echo pulse signal utilizing a peak holding circuit and a medium to low-speed ADC in an example;
FIG. 5 shows a waveform schematic diagram of sampling echo pulse signals utilizing a peak holding circuit and a medium to low-speed ADC in an example;
FIG. 6 shows a schematic diagram of a partial structure of a light detection circuit in an embodiment of this disclosure;
FIG. 7A shows a structural schematic diagram of a connection between an array of switches and an array of photodetector units in a light detection circuit in an embodiment of this disclosure;
FIG. 7B shows a structural schematic diagram of a connection between an array of switches and an array of photodetector units in a light detection circuit in another embodiment of this disclosure;
FIG. 8 shows a structural schematic diagram of a light detection circuit in another embodiment of this disclosure;
FIG. 9 shows a circuit schematic diagram of a Buck-Boost switching power source in an embodiment of this disclosure;
FIG. 10 shows a structural schematic diagram of a light detection circuit in a further embodiment of this disclosure;
FIG. 11 shows a circuit schematic diagram of a level shifter in an embodiment of this disclosure;
FIGS. 12A to 12E show circuit schematic diagrams of variant examples of level shifters in several embodiments of this disclosure;
FIG. 13 shows a structural schematic diagram of a light detection circuit in an additional embodiment of this disclosure;
FIG. 14A shows a circuit schematic diagram of an RC integral operator unit in an embodiment of this disclosure;
FIG. 14B shows a circuit schematic diagram of a Gm-C integral operator unit in an embodiment of this disclosure;
FIG. 15 shows a structural schematic diagram of a light detection circuit in a specific embodiment of this disclosure;
FIG. 16 shows a structural schematic diagram of a LiDAR in an embodiment of this disclosure;
FIG. 17 shows a structural block diagram of a pulse signal peak detection system in an embodiment of this disclosure;
FIG. 18 shows a schematic diagram of the principle of generation of control signals and a reset signal in an embodiment of this disclosure;
FIG. 19 shows a waveform schematic diagram of an input signal and an output signal of a first comparator in an embodiment of this disclosure;
FIG. 20 shows a schematic diagram of a peak detection circuit in an embodiment of this disclosure;
FIG. 21 shows a schematic diagram of respective multi-channel sampling and holding circuits in a multi-channel sampling and holding circuit in an embodiment of this disclosure;
FIG. 22 shows a schematic diagram of a specific structure of an analog-to-digital conversion circuit in a pulse signal peak detection system in an embodiment of this disclosure;
FIG. 23 is a circuit schematic diagram of a pulse signal peak detection system based on the analog-to-digital conversion circuit structure shown in FIG. 22;
FIG. 24 is a time sequence diagram of respective signals in the embodiment shown in FIG. 22;
FIG. 25 shows a schematic diagram of another specific structure of an analog-to-digital conversion circuit in a pulse signal peak detection system in another embodiment of this disclosure;
FIG. 26 shows a structural schematic diagram of a LiDAR provided in another embodiment of this disclosure.

### DETAILED DESCRIPTION

The embodiments of this disclosure are described below through specific examples. Those skilled in the art can easily understand other advantages and effects of this disclosure from the content disclosed in this specification. The system of this disclosure can also be implemented or applied through other different specific implementations. Various details in this specification can also be modified or changed in various ways based on different viewpoints and disclosure systems without departing from the spirit of this disclosure. It should be noted that, as long as there is no conflict, the embodiments and features in the embodiments of this disclosure can be combined with each other.

The embodiments of this disclosure are described below in detail with reference to the drawings, so that those skilled in the art can implement this disclosure easily. This disclosure may be embodied in many different ways, which are not limited to the embodiments described here.

To clarify this disclosure, some irrelevant components are omitted. Same or similar elements throughout the specification are denoted by the same reference numeral.

Throughout the specification, when it is described that some component is "coupled" or "connected" with another component, this covers "direct connection" and also "indirect connection" in which a further element is provided therebetween. Further, when it is described that some component "includes" a certain element, this does not exclude another element, but means that it can include another element, unless specified otherwise.

When it is described that some component is on/above another component, this can mean that the component is immediately on/above the other component, and can also means that there is a further component therebetween. When it is described that the component is directly or immediately on/above the other component, there is no further component therebetween.

Although the terms such as "first" and "second" are used to describe various elements in some embodiments, those elements should not be limited by such terms. These terms are used only to distinguish one element from another element, for example, a first interface and a second interface. Further, as used in the specification, the singular forms "a", "an", "one" and "the" intend to include plural forms, unless specified otherwise in the context. It shall be understood that the terms "include" and "comprise" indicates that the recited features, steps, operations, elements, components, projects, types and/or groups are present, but this does not exclude the presence, appearance or addition of one or more other features, steps, operations, elements, components, projects, types and/or groups. The terms "or" and "and/or" used here shall be interpreted as inclusive, or refer to any one of them or any combination. Therefore, the expression "A, B or C" or the expression "A, B and/or C" include any of the following: A; B; C; A and B; A and C; B and C; A, B and C. Only when there are some implicit conflicts in the combination of the elements, functions, steps or operations in certain ways, the exception of the above definition can appear.

Those technical terms used here only apply to the specific embodiments, and do not intend to limit this disclosure. The singular form used here also covers a plural form, unless specified otherwise clearly. The term "include" used in the specification means to specify those specific characteristics, regions, integers, steps, tasks, elements and/or components, and does not exclude the presence or addition of other characteristics, regions, integers, steps, tasks, elements and/or components.

Terminologies describing relative spatial positions, such as "on" and "below", are used to make it easier to describe the relationship of a device illustrated in the drawings relative to another device. Those terminologies not only have the meanings indicated in the drawings, but also have other meanings or tasks of the device in use. For example, if the device in the drawings is overturned, some component that was described to be under/below another component are described to be on/above the other component. Therefore, such example terminologies as "below", covers above and below. The device can be rotated 90 degree or another degree, and terminologies indicating relative spatial relationship can be explained accordingly.

All the terminologies, such as the technical terminologies and scientific terminologies used here, have the same meaning as what those skilled in the art can understand, although there is no different definition. Supplemental explanation about a term in an ordinary dictionary has a meaning complying with relevant technical articles and contents in this prompt, and it shall not be unduly explained as having an ideal or very formula meaning, as long as it is not defined.

Typically, in a signal processing circuit of a detection end of a LiDAR, a voltage amplifier can be disposed in the front stage to convert an electrical signal (e.g., a current signal) output through optical-electrical conversion by a photodetector into a voltage signal for further processing in the back stage. However, as shown in FIG. 2, during the operation process of an array of photodetectors, photodetectors in a measurement channel operate together, while photodetectors in non-measurement channels are still in a "waiting" state. Therefore, the photodetectors in the non-measurement channels can produce external interference, which can cause crosstalk to the measurement channel, and the waiting state of the photodetectors in the non-measurement channels also causes a large amount of unnecessary power consumption.

This disclosure provides a light detection circuit for a LiDAR in the following embodiment to solve the problem described above.

In FIG. 6, a schematic diagram of a partial structure of a light detection circuit in an embodiment of this disclosure.

In the embodiments in association to FIG. 6, the light detection circuit as shown includes: an array of photodetector units 301, an array of switches 302, and a selector unit 303.

The array of photodetector units 301 includes a plurality of photodetector units 311, each photodetector unit 311 can include at least one photodetector. The photodetector can be a SiPM or a SPAD. Respective photodetector units 311 can receive light signals and generate corresponding electrical signals, and the electrical signals can be current signals as an example.

The array of switches 302 includes a plurality of first switch units 321. Each first switch unit 321 is correspondingly coupled to a photodetector unit 311. Each first switch unit 321 is configured to control an operating state of the coupled photodetector unit 311, such that a signal output terminal of the coupled photodetector unit 311 outputs the electrical signal. For example, one terminal of a first switch unit 321 is coupled to a first power supply terminal and connected to an operating voltage, and when the first switch unit 321 is selected to be ON, which causes the coupled photodetector unit 311 to obtain the operating voltage and to be in the operating state, a measurement channel corresponding to the photodetector unit 311 in the operating state operates; other first switch units 321 can be correspondingly in an OFF state, such that the coupled photodetector units 311 are in a non-operating state and thereby cannot be subject to external interference, and no interfering electrical signals can be generated, and power consumption can also be saved.

The selector unit 303 can select a photodetector unit 311 in the operating state to output the electrical signal. For example, the selector unit can be a multiplexer.

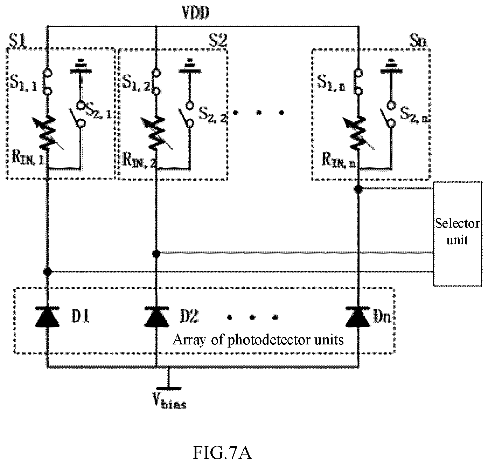

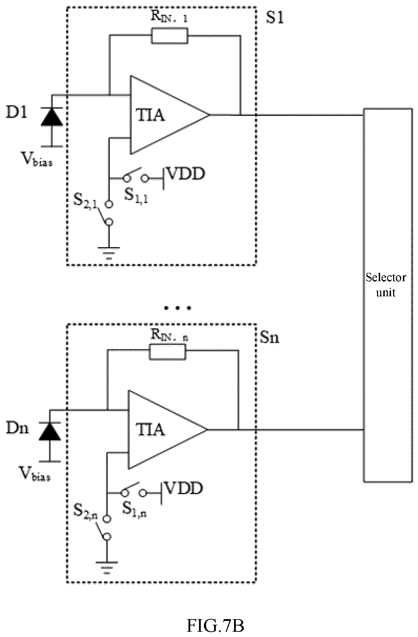

Connection structures between the array of switches and the array of photodetector units in FIG. 6 can be illustrated below through the embodiments in association with FIGS. 7A and 7B.

In FIG. 7A, a structural schematic diagram of a connection between the array of switches and the array of photodetector units in the light detection circuit in an embodiment of this disclosure is shown.

The diagram shows the first power supply terminal coupled to a power supply source to provide an operating voltage (e.g., VDD), the operating voltage can generate a reverse bias voltage activating photodetector units (e.g., SPAD and SiPM) in the array of photodetector units.

The array of switches shown in the diagram includes a plurality of first switch units, which are examples shown as n units, namely S1~Sn. And there are n photodetector units D1~Dn in the corresponding array of photodetector units.

Taking a first switch unit S1 as an example for explanation. The first switch unit includes: a first switching element S_{1,1} with one terminal coupled to the first power supply terminal, and the other terminal coupled to one terminal of a photodetector unit D1. The terminal (e.g., corresponding to a negative pole of D1) of the photodetector unit D1 coupled to the first switching element is a signal output terminal and can be coupled to one input terminal of the selector unit. A switch state of the first switching element S_{1,1} corresponds to the ON/OFF of a path between the first power supply terminal and the signal output terminal. For example, when the first switching element S_{1,1} is ON, the line from the VDD of the first power supply terminal to the V_{bias} of a positive pole of the photodetector unit D1 is ON to apply a reverse bias voltage to the photodetector unit D1, and cause the photodetector unit D1 to operate; alternatively, when the first switching element S_{1,1} is OFF, the line from the first power supply terminal to the positive pole of the photodetector unit D1 is OFF, so as to cause the photodetector unit D1 to be in the non-operating state.

In the example of FIG. 7A, a bias voltage V_{bias} can be connected to one terminal corresponding to the positive pole of the photodetector unit D1, the bias voltage V_{bias} and a voltage formed when the negative pole of the photodetector unit D1 is ON by the first switching element S_{1,1}to form a reverse bias voltage (higher than the breakdown voltage Vₜₕ of the photodetector unit D1) which causes the photodetector unit D1 to operate. For example, the first switching element S_{1,1} can also be coupled to one terminal of the photodetector unit D1 through an impedance R_{IN, 1} (e.g., a resistor) to convert a current signal, obtained through conversion of the light signal by the photodetector unit D1, into a voltage signal to be outputted from the signal output terminal.

Due to the high reverse bias voltage of the photodetector unit, there is a possibility of damage to S_{1,1} and R_{IN, 1} due to overvoltage. For this purpose, in an optional example, the first switch unit further includes: a second switching element S_{2,1} with one terminal coupled to one terminal of the photodetector unit D1 coupled to the first switching element S_{1,1}, and the other terminal coupled to a ground terminal; wherein a switch state of the second switching element S_{2,1} corresponds to ON/OFF of a path between the signal output terminal and the ground terminal. Therefore, the second switching element S_{2,1}, when being ON, can ground an output voltage of the photodetector unit D1, preventing the overvoltage problem. Optionally, in addition to being coupled to the ground terminal, the second switching element S_{2,1} can also be connected to another bias that does not exceed VDD.

For example, when the photodetector unit D1 is not required to operate, the second switching element S_{2,1} can be ON and the first switching element S_{1,1} can be OFF to ground the negative pole of the photodetector unit D1 and enable the photodetector unit D1 in a non-activatable state; when the photodetector unit D1 is required to operate, the second switching element S_{2,1} can be OFF, and the first switching element S_{1,1} can be ON, so as to enable the photodetector unit D1 to be in the operating state.

It can be understood that, as above examples, the switch states of the second switching element and the first switching element correspond to the setting of the operating or non-operating state of the corresponding coupled photodetector unit, respectively. Therefore, in some examples, the switch states of the first switching element and the second switching element can be mutually matched, for example, being set to be opposite.

For example, when the photodetector unit D1 is in a measurement channel, the first switching element S_{1,1} is set to be ON and the second switching element S_{2,1} is set to be OFF, so that the photodetector unit D1 is in the operating state; and when the photodetector unit D1 is in a non-measurement channel, the first switching element S_{1,1} is set to be OFF and the second switching element S_{2,1} is set to be ON, so that the photodetector unit D1 is in the non-operating state, which cannot generate additional power consumption or detect external interference light signals.

In a specific example of implementation, the first switching element S_{1,1} can be a PMOS; alternatively, it can be a bootstrap NMOS with smaller parasitic capacitance and ON impedance, and faster switching speed. The second switching element S_{2,1} can be a NMOS.

In a specific example of implementation, the impedance value of R_{IN, 1} can be fixed or variable (e.g., implemented as a variable resistor). When R_{IN, 1} is a variable impedance, the impedance value (like the resistance value) of R_{IN, 1} can be regulated based on demands to change the gain of the output signal of the photodetector unit. For example, if some measurement channels are required to perform a long-range measurement (e.g., hundreds of meters away, like 150 meters, 250 meters, or the like), the gain can be improved by increasing the impedance value of R_{IN, 1}, so as to increase the pulse amplitude generated by the photodetector unit in response to a single photon; and when the corresponding measurement channels are required to perform a short-range measurement, the impedance value of R_{IN}, ₁ is decreased to reduce the gain. In specific examples of implementation, when R_{IN, 1} is a variable resistor, its resistance range can be from tens of ohms to hundreds of ohms.

The connection structures of S2~Sn can be the same as that of S1, for example, a first switching elements S_{1,2}, an impedance R_{IN, 2}, and a second switching element S_{2,2} of S2 are the same as the connection structure of S1, and the rest can be done in the same manner until a first switching element S_{1, n}, an impedance R_{IN, n}, and a second switching element S_{2, n} of Sn. Further optionally, there is the same configuration among S_{1,1}∼S_{1, n}, among S_{2,1}∼S_{2, n}, and among R_{IN, 1}∼R_{IN, n}. S1∼Sn independently control the operating states of D1~Dn, that is, respectively controlling the operating states of D1∼Dn through S1∼Sn in the array of switches. When the first switching element (e.g., S_{1,1}) in the first switch unit (e.g., S1) is ON, the corresponding measurement channel is gated, such that the corresponding photodetector unit (e.g., D1) detects the light signal and generates the corresponding electrical signal; correspondingly, by controlling first switching elements of other first switch units (e.g., S2~Sn) to be OFF (the second switching elements can be set to be ON), photodetector units (e.g., D2~Dn) in the non-measurement channels can be OFF, which causes their power consumption close to zero and not to detect light signals.

In a specific example of implementation, to achieve rapid switching between multiple measurement channels and real-time closure of non-measurement channels, a switching time between the measurement channels can be 200ns as an example, and the first switching element and the second switching element in each first switch unit can rapidly switch the switch states at a switching time of 10-20ns.

Accordingly, the operation of the array of photodetector units is controlled through the aforesaid array of switches, meeting the objectives of reducing power consumption and decreasing crosstalk in the measurement channel.

In practical examples, the array of photodetector units can be in a linear array or an area array, and there can be one or more photodetector units that correspondingly belong to each measurement channel. When each measurement channel corresponds to a plurality of photodetector units that operate together, the plurality of detection units that operate together can be the ones adjacent or dispersed in a column or row of the array, or dispersed based on other rules. In these cases, the manner of the array of switches controlling the array of photodetector units in the aforesaid embodiments can be applied, so as to independently control one or more photodetector units that belong to a measurement channel to be in the operating state, and control one or more photodetector units that belong to a non-measurement channel to be in the non-operating state, thereby meeting the aforesaid objectives of reducing power consumption and decreasing crosstalk in the measurement channel.

The selector unit in FIG. 7A selects communication with the signal output terminal of the photodetector unit that belongs to a measurement channel to output to a back-stage signal processing circuit.

FIG. 7A example shows an embodiment of a specific circuit implementation in FIG. 6, without limiting the possibilities of other embodiments.

For example, in FIG. 7B, a structural schematic diagram of a connection between the array of switches and the array of photodetector units in the light detection circuit in another embodiment of this disclosure is shown.

In the embodiment shown in FIG. 7B, the main difference from the embodiment of FIG. 7A lies in that each first switch unit S1∼Sn includes a trans-impedance amplifier unit (TIA) including a first input terminal, a second input terminal, and an output terminal. For example, the trans-impedance amplifier unit can be implemented as a TIA, and its structure can be referred to FIG. 1B. The first and second input terminals can be one and the other of the positive and negative pole input terminals, respectively, and the voltages of the first and second input terminals are the same based on the principle of "virtual short" in an operational amplifier.

The first switch units S1∼Sn respectively include the first switching elements S_{1,1}∼S_{1,n} and the second switching elements S_{2,1}∼S_{2,n}. As representatively explained by taking the first switch unit S1 as an example, the first input terminal of the trans-impedance amplifier unit is coupled with the first switching element S_{1,1} to the first power supply terminal (e.g., connected to the operating voltage VDD in the diagram), and coupled with the second switching element S_{2,1} to the ground terminal; the second input terminal of the trans-impedance amplifier unit is coupled to one terminal of the photodetector unit D1, and coupled to the output terminal of the trans-impedance amplifier unit through an impedance unit R_{IN,1}; the output terminal of the trans-impedance amplifier unit is coupled to the signal output terminal, and coupled to one input terminal of the selector unit through the signal output terminal. The connection structures of S2~Sn are the same as that of S 1, and the connection structure such as the photodetector unit Dn, the impedance unit R_{IN, n}, the first switching elements S_{1,n}, and the second switching elements S_{2,n} of the first switch unit Sn in FIG. 7B will not be repeated here.

When the first switching element S_{1,1} is ON, VDD is transmitted to the first input terminal, and the voltage of the second input terminal is correspondingly VDD, and is thereby applied to the negative pole of the coupled photodetector unit D1 to cause the same to be in the operating state; alternatively, when the first switching element S_{1,1} is OFF, the second switching element S_{2,1} is ON, the negative pole of the photodetector unit D1 is equivalent to a ground to cause the photodetector unit D1 to be in the non-operating state.

In the aforesaid embodiment, the selector unit includes controllable switches to gate output signals of photodetector units that belong to different measurement channels. In some examples, the selector unit, as well as the first and second switching elements, can be controlled by a clock signal provided by a controller or waveform generator. Specifically, the first switching element can be ON and the second switching element can be OFF before controlling the gating of the selector unit; alternatively, it is also possible to simultaneously make the first switching element ON, and the second switching element OFF, and control the gating of the selector unit.

Given that different types of photodetector units require different operating voltages, the fixed VDD power supply as shown in the example in FIG. 2, if used, cannot meet the requirements for different types of photodetector units.

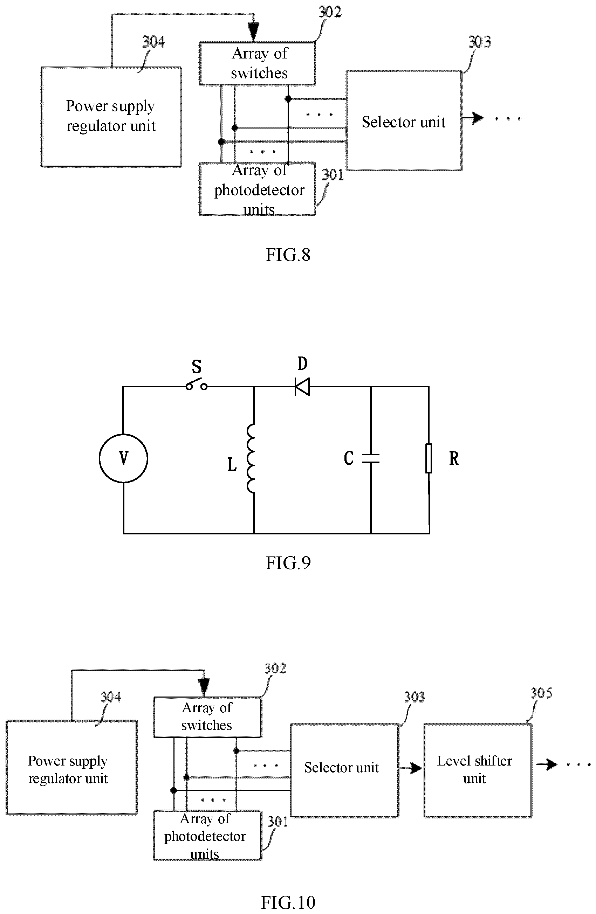

For this purpose, in FIG. 8, a structural schematic diagram of a light detection circuit in another embodiment of this disclosure is shown. The light detection circuit in the embodiment of FIG. 5 is added with a power supply regulator unit 304 on the basis of the light detection circuit (including the array of photodetector units 301, the array of switches 302 and the selector unit 303) of FIG. 6.

The power supply regulator unit 304 has an output terminal connected to the first power supply terminal to provide a variable power supply source. Specifically, the power supply regulator unit 304 can provide a regulatable power supply voltage VDD, providing a suitable reverse bias voltage for photodetector units in different measurement channels. For example, the voltage regulation range of the power supply regulator unit 304 can be determined based on the operating voltage of photodetector units (e.g., one or more SPADs, or SiPMs) produced by different manufacturers or processes. The voltage value regulation of the power supply regulator unit 304 can be continuous or discontinuous. For example, in the case of continuous regulation of the voltage value, the voltage regulation range can range from 4 volts to tens of volts. Further, for example, in the case of discontinuous regulation of the voltage value, a plurality of discrete voltage values as provided can be chosen as the VDD, such as, 4V, 8V, 12V, or the like, corresponding to the operating voltages of different photodetector units respectively.

In some embodiments, the power supply regulator unit 304 can be implemented by a Buck-Boost switching power source to achieve a regulatable boost or buck function.

In FIG. 9, a circuit schematic diagram of a Buck-Boost switching power source in an embodiment of this disclosure is shown.

The Buck-Boost switching power source includes: a voltage source V, a switch S, a diode D, an inductor L, a capacitor C, and a resistor R.

One terminal of the voltage source is coupled to one terminal of the switch S, the other terminal of the switch S is coupled to one terminal of the inductor L and a negative pole of the diode D, and a positive pole of the diode D is coupled to one terminal of the capacitor C and one terminal of the resistor R; and the other terminals of the inductor L, the capacitor C, and the resistor R are coupled to the other terminal of the voltage source. An output voltage of the Buck-Boost switching power source is a voltage across R.

When the switch S is ON, the voltage source V stores energy through the inductor L, and at this time, the capacitor C discharges to supply power to the load R, achieving the buck function; and when the switch S is OFF, a reverse electromotive force is generated on the inductor L, causing the diode D to switch from cutoff to ON. The inductor L supplies power to the load R and charges the capacitor C, ultimately maintaining the output voltage unchanged and achieving the boost function.

It need be noted that the circuit structure of the switching power source in FIG. 9 is only illustrative. In other embodiments, the power supply regulator unit can also be implemented by other types of regulatable switching power sources or linear power sources, such as a low dropout regulator (LDO). However, it need be noted that a switching power source is more suitable in the application scenarios of the light detection circuits that requires a high voltage drop based on SiPM, or the like of the LiDAR.

Still referring to FIG. 10, it shows a structural schematic diagram of a light detection circuit in a further embodiment of this disclosure. In this embodiment, compared to the light detection circuit (including the array of photodetector units 301, the array of switches 302, the selector unit 303, and the power supply regulator unit 304) in the embodiment of FIG. 8, a level shifter unit 305 is added.

The level shifter unit 305 has an input terminal coupled to the output terminal of the selector unit 303, and can convert the voltage output by the selector unit to a predetermined voltage range. Specifically, the predetermined voltage range is determined by an operating voltage limit of a signal processing circuit in the back stage of the selector unit.

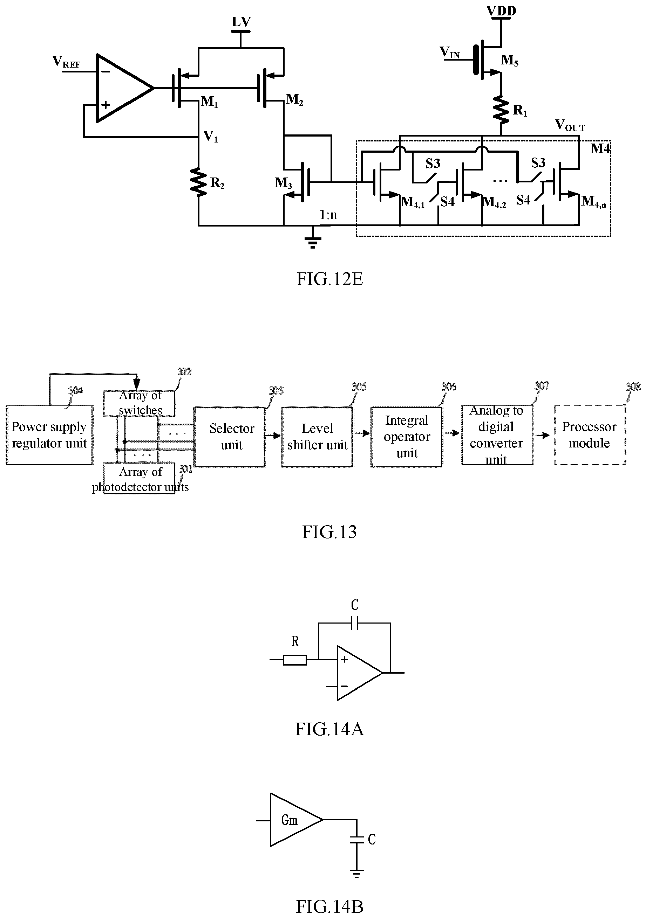

In one aspect, since the operating voltage of the array of photodetector units is a high voltage, the corresponding electrical signal selected and output by the selector unit 303 is also a high voltage signal. There can be a circuit operating at a low voltage in the signal processing circuit in the back stage of the selector unit, so the conversion from a high voltage to a low voltage is conducted by the level shifter unit 305. For example, the operating voltage of the SiPM is typically high, with a typical value above 10V. Reference can be made to FIG. 13 below, and the signal processing circuit in the back stage of the selector unit can include an integral operator unit 306. To achieve a sufficient speed, the integral operator unit 306 is typically implemented by using a low-voltage device. For example, the integral operator unit 306 has a typical withstand voltage of 1.8V, and is thus a low-voltage element. The output signal with an amplitude of tens of volts is converted into a signal of 1.8V by the level shifter unit 305, the converted signal is input into the integral operator unit 306.

In another aspect, the voltage regulation effect of the power supply regulator unit, such as a change in VDD, can cause a voltage change in the output signal of the photodetector unit, and can cause unstable voltages of the input and output signals of the back-stage signal processing circuit, resulting in the difficulty in designing devices in the back-stage signal processing circuit. By disposing the level shifter unit 305, the difficulty in designing devices in the back-stage signal processing circuit can be further reduced. For example, reference to FIG. 13 below, where an analog to digital converter 307 (ADC) is disposed in the back stage of the integral operator unit 306. The level shifter unit 305 decreases the voltage of the input signal before the integral operator unit 306, which can correspondingly reduce the difficulty in designing the subsequent analog to digital converter unit 307 and improve measurement precision. For example, the precision of the ADC is 1mV, and its input voltage is required to be held at 1V; and if the voltage is unstable, and the input voltage of the ADC becomes 3V, for the same ADC, the significant bit remains unchanged, such as 10 bits, reducing measurement precision. However, these problems can be solved by the level shifter unit 305 that, before the integral operator unit 306, converts the output signal of the selector unit into an input signal with a stable voltage value inputting the integral operator unit 306.

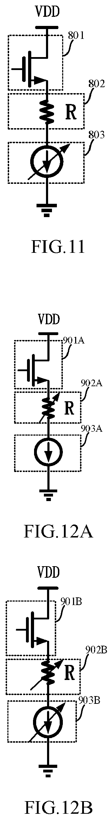

In FIG. 11, a circuit schematic diagram of a level shifter unit in an embodiment of this disclosure is shown.

The level shifter unit includes at least one second switch unit 801, a first impedance unit 802, and a current source 803.

Each of the second switch units 801 includes: a first terminal coupled to the first power supply terminal, a second terminal coupled to one terminal of the first impedance unit 802, and a control terminal coupled to the output terminal of the selector unit 303; the control terminal can control the ON-OFF of the first terminal and the second terminal; and the other terminal of the first impedance unit 802 is coupled to one terminal of the current source 803, and the other terminal of the current source 803 is coupled to the ground terminal.

The principle of the level shifter unit illustrated in FIG. 11 is a voltage follower. The diagram schematically shows that the current source 803 is a variable current source that can actively self-regulate the output current. By regulating the magnitude of current of the current source 803, different level shifts are achieved. Therefore, when the voltage of the output signal of the photodetector unit changes, the level shifter unit follows the change to make its output voltage range unchanged.

In some embodiments, the second switch unit 801 can be implemented by a MOS, for example, a NMOS schematically shown in the diagram, with a drain as the first terminal, a source as the second terminal, and a gate as the control terminal (which can be coupled to the output terminal of the selector unit in the front stage). In some embodiments, the first impedance unit 802 can be implemented as a resistor or a plurality of MOSs connected in series. The impedance value (e.g., resistance value) of the first impedance unit 802 is fixed or variable; the current source 803 can also be a current source that changes the output current with a change in the resistance value of the first impedance unit 802, to match the variable impedance value of the first impedance unit 802, or be a variable current source that can actively self-regulate the output current to match the invariable impedance value of the first impedance unit 802.

Several possible variants of the circuit structure of the level shifter unit are shown below through several embodiments and drawings.

In FIGS. 12A to 12E, there are shown schematic diagrams of the circuit structures of several variants of the level shifter unit in the embodiments of this disclosure.

As shown in FIG. 12A, the second switch unit 901A is implemented as one NMOS, the first impedance unit 902A is implemented as a variable resistor R, and the current source 903A is a current source. The output voltage of the level shifter unit can be regulated by the variable resistor R.

As shown in FIG. 12B, the second switch unit 901B is implemented as one NMOS, the first impedance unit 902B is implemented as a variable resistor R, and the current source 903B is a variable current source. The output voltage of the level shift power source can be regulated by both the variable resistor and the variable current source.

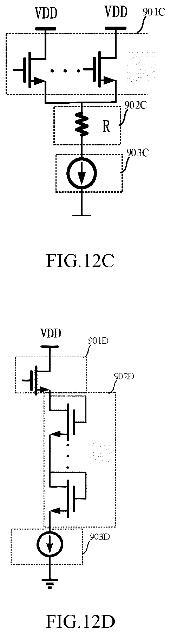

As shown in FIG. 12C, the second switch unit 901C is implemented as a plurality of NMOSs connected in parallel, with sources connected to one another, drains all coupled to the first power supply terminal providing VDD; the first impedance unit 902C is implemented as an invariable resistor R, and the output current of the current source 903C depends on the first impedance unit 902C. The output voltage of the level shifter unit is regulated by regulating the number of NMOSs.

As shown in FIG. 12D, the second switch unit 901D is implemented as one NMOS. The first impedance unit 902D can be implemented by a transistor. Specifically, the transistor can be a field-effect transistor (e.g., PMOS and NMOS), and as examples in association with FIG. 12D, the first impedance unit 902D is implemented by connecting a plurality of NMOSs in series, different numbers of NMOSs corresponding to different impedance values, so as to replace the variable resistor. Specifically, the connection manner of connecting in series the plurality of NMOSs in the first impedance unit 902D refers to that the gate and source of each NMOS are coupled, the gate of the first NMOS is connected to the source of the NMOS in the second switch unit 901D, and the source of the last NMOS is coupled to one terminal of the current source; and the gate of each NMOS other than the first and last NMOS is coupled to the source of the previous one NMOS. In this example, the output current of the current source 903D depends on the impedance of the first impedance unit 902D. The output voltage of the level shifter unit can be regulated by regulating the number of NMOSs.

FIGS. 12A-12D only examples, not exhaustively, show several possible variants of the first impedance unit. It can be understood that various arrangement and combination manners among the implementation of the second switch unit of the level shifter unit, the implementation/variableness/invariableness of the first impedance unit, and the implementation/variableness/invariableness of the current source can all be covered within the scope of protection of this disclosure, and are not be listed one by one here.

Further, in FIG. 12E, a circuit schematic diagram of a level shifter unit including a specific circuit structure of a current source is shown.

In this illustrated embodiment, the current source includes a first current mirror circuit and a second current mirror circuit.

The first current mirror circuit includes a first branch and a second branch respectively led out by at least one pair of common-gate transistors M₁ and M₂, with the gate coupled to the control terminal of the current source; a second impedance unit R₂ is connected in series in the first branch; one terminal of the first branch and one terminal of the second branch are coupled to the second power supply terminal, and the other terminal of the first branch is grounded through the second impedance unit; and voltages connected to the second power supply terminal and the first power supply terminal are different. In an optional example, as shown in FIG. 12E, the pair of common-gate transistors M₁ and M₂ in the first current mirror circuit are specifically implemented as at least one first PMOS and at least one second PMOS connected through a common gate and a common source, that is, the branches where the transistors M₁ and M₂ are respectively located are the first and second branches. At least one first PMOS and at least one second PMOS are connected through a common gate and the gate is coupled to the control terminal of the current source, and the source for the common-source connection is connected to the second power supply terminal; a drain of the first PMOS is coupled to the ground terminal through the second impedance unit; wherein voltages connected to the second power supply terminal and the first power supply terminal are different. For example, in the diagram, the VDD connected to the first power supply terminal is a high voltage HV, while the voltage connected to the second power supply terminal is a low voltage LV.

The second current mirror circuit includes a third branch and a fourth branch respectively led out by at least one pair of common-gate transistors (M₃ and M_{4,1}-M_{4,n} in parallel); one terminal of the third branch is coupled in series to the other terminal of the second branch, and the other terminal of the third branch is coupled to the ground terminal; one terminal of the fourth branch is coupled to one terminal of the first impedance unit R₁, and the other terminal of the fourth branch is grounded to form a ratio relationship between currents flowing through the second impedance unit R₂ and the first impedance unit R₁. In an optional example, a pair of common-gate transistors in the second current mirror circuit is specifically implemented as a first NMOS (which can be one as the illustrated example, or more in parallel, i.e., M₃) and at least one second NMOS (which is shown in the diagram as more in parallel, i.e., M_{4,1}-M_{4,n}) connected through a common gate and a common source, the branches where M₃ and M_{4,1}-M_{4,n} are located respectively are the third and fourth branches. The gate and drain of M₃ are coupled to a drain of the second PMOS (M₂), and a source of M₃ is coupled to the ground terminal; and M_{4,1}-M_{4,n} are connected with M₃ through a common gate, the drains are coupled to one terminal of the first impedance unit R₁, and the sources are coupled to the ground terminal.

The fourth branch includes n (n≥2) sub-branches, each sub-branch includes a transistor (i.e., one of the second NMOSs M_{4,1}-M_{4,n}), wherein the transistor of each sub-branch can be selected to be connected to or disconnected from the transistor in the third branch to regulate a ratio value between the currents flowing through the first impedance unit and the second impedance unit. In a specific example of implementation, as shown in FIG. 12E, the drains of M_{4,1}-M_{4,n} are coupled to one another and coupled to one terminal of the first impedance unit R₁, producing an output voltage Vₒᵤₜ.

M_{4,1}∼M_{4,n} form a transistor array M4. A gate of each of M_{4,2}∼M_{4,n} is coupled to the gate of M_{4,1} through its respective third switching element S3, and coupled to the ground terminal through a fourth switching element S4.

Optionally, the current source also includes an operational amplifier, the operational amplifier includes: a negative input terminal connected to a reference voltage V_{REF}; a positive input terminal coupled to one terminal of the second impedance unit R₂ to apply the reference voltage, the other terminal of the second impedance unit R₂ being grounded; and an output terminal used as a control terminal of the current source. In specific examples, V_{REF} is typically 1V-1.2V, with high precision and temperature independence, and a negative feedback loop including the operational amplifier and the first PMOS (i.e., M₁) causes the voltage to satisfy V₁=V_{REF}.

The current generated in each branch of a current mirror circuit is proportional to the number of MOS transistors in each branch. It need be noted that although each of M₁, M₂, M₃, and M₅ is shown as one in the illustrated example, its actual number can vary, which, for example, can be implemented by connecting a plurality of MOS transistors in parallel, and reference can be made to the 901C and so on in FIG. 12.

For example, in the first current mirror circuit, the device parameters and device numbers of M₁ and M₂ are the same, so that the current flowing through M₂ in the second branch is equal to the current flowing through R₂ in the first branch.

In the second current mirror circuit, the device parameters of M₃ are the same as those of each NMOS in M_{4,1}-M_{4,n}, with a number ratio of 1: n. Therefore, the ratio relationship between the currents flowing through R₂ and R₁ is 1: n. The voltage across the first impedance unit R₁ are n*V_{REF}/R₂*R₁, and the value of n is regulated by turning ON or OFF the switches S3 and S4 to regulate the current ratio relationship to achieve precise control of the voltage across R₁. Further, the Vₒᵤₜ is output stably through a stable V_{REF}. The gate of the second switch unit M₅ is connected to the output terminal of the selector unit to receive the voltage signal output by the photodetector unit of the selected measurement channel. The voltage at the first power supply terminal is the VDD as above examples, with an example amplitude of 12V. The example amplitude of the voltage LV at the second power supply terminal is 1.8V or 5V

The voltage between V_{IN} and Vₒᵤₜ is a sum of the gate-source voltage of the second switching element M₅ (which, not shown, can be denoted as V_{GS}) and the voltage across the first impedance unit R₁. Among others, the gate-source voltage V_{GS} is only related to the current flowing through the first impedance unit R₁, and the current flowing through the first impedance unit R₁ is determined by the ratio of the numbers of transistors in M₃ and M₄, so that precise control of voltage regulation of the level shifter unit can be achieved by regulating the switch state of each transistor in M₄. Specifically, when S3 connected to the gate of a transistor in M₄ is ON and S4 is OFF, the transistor is in an ON state, and the current flows through the branch where the transistor is located; alternatively, when S3 connected to the gate of a certain transistor in M₄ is OFF and S4 is ON, the transistor is in an OFF state, and no current flows through the branch where the transistor is located. Therefore, when more transistors are ON in M₄, the current flowing on the first impedance unit R₁ is greater, so as to increase the voltage across R₁; on the contrary, when fewer transistors are ON in M₄, the voltage across R₁ is smaller.

The first PMOS (M₁), second PMOS (M₂), first NMOS (M₃), and at least one second NMOS (M_{4,1}-M_{4,n}), as well as the second switching element (M₅), can all be high-voltage-resistant transistors.

In some embodiments, operating voltages of devices (e.g., SiPM or SPAD) of different types of photodetector units are different, which can be 4V, 8V, and 12V as examples. In practical applications, the operating voltage parameters of each photodetector unit can be measured in advance, for example, an operating voltage of 4V of the photodetector unit D1, and an operating voltage of 12V of the photodetector unit D3, and the measured operating voltage parameters can be stored in a storage medium (e.g., a register, RAM, ROM, and hard disk, or the like) for reading and controlling the power supply regulator unit to correspondingly provide an adapted voltage value VDD for the photodetector unit in each measurement channel, thereby providing a suitable reverse bias voltage for the photodetector unit to be activated to operate.

Additionally, in some embodiments, a temperature sensor can also be added to the light detection circuit to detect an ambient temperature of the circuit, to further correspondingly compensate for and calculate a reverse breakdown voltage of the photodetector unit with the detected temperature change. Specifically, the breakdown voltage values at different temperatures are obtained and fed back to the storage medium. In the storage medium reverse breakdown voltage change values and matched reverse bias voltage values can be correlated and stored in advance, thereby providing a suitable reverse bias voltage value based on a reverse breakdown voltage change value, which can control the power supply regulator unit to set a compensated VDD. In some examples, a look-up table can also be set up to correlate and store the reverse breakdown voltage change values and the matched reverse bias voltage values for lookup of a reverse bias voltage value.

In FIG. 13, a structural schematic diagram of a light detection circuit in an additional embodiment of this disclosure is shown.

Compared to FIG. 10, the signal processing circuit in the back stage of the level shifter unit as shown in FIG. 13 further includes an integral operator unit 306 and an analog-to-digital converter unit 307.

The integral operator unit 306 is coupled to the output terminal of the level shifter unit 305 for performing an integral operation based on a received electrical signal to obtain an operation result. In some embodiments, the integral operator unit 306 can include an integrator that can be a low-voltage device with an operating voltage that can be 1.8V, and 5V, or the like as examples, so that the level shifter unit 305 in the front stage converts the output signal of the selector unit from the high voltage to a low voltage suitable for the integrator, and inputs the converted output signal into the integrator for the integral operation.

In an disclosure example, a suitable operating voltage is provided by the power supply regulator unit for the array of photodetector units to generate a suitable reverse bias voltage, so that the photodetector unit operates normally. During detection of an echo signal, at least one first switching element in the array of switches corresponding to a measurement channel is made ON (or a second switching element can also be made OFF at the same time) through a switch control signal, such that at least one photodetector unit as coupled belonging to the measurement channel is in the operating state; and the first switching element corresponding to a non-measurement channel is made OFF (or a second switching element can also be made ON at the same time), such that at least one photodetector unit as coupled belonging to the non-measurement channel is in the non-operating state, and thus at least one photodetector unit belonging to the non-measurement channel cannot produce unnecessary power consumption and cannot detect external interference light to cause crosstalk to the measurement channel.

Further, an output signal of the measurement channel is gated by the selector unit 303, input to the level shifter unit 305 for level conversion, for example, from a high voltage to a low-voltage signal suitable for the back-stage integral operator unit 306, which is input to the integral operator unit 306. The integral operator unit 306 performs an operation of energy information of an echo signal obtained from the measurement channel based on the input signal so as to obtain an analog signal form of the energy information. The analog signal can be outputted to the analog-to-digital converter unit 307 and converted into a digital signal of the energy information. The digital signal is further sent to, for example, a controller module 308 of the LiDAR for calculating a detection result of this measurement channel.

In some embodiments, the circuit implementation of the integral operator unit 306 can be as shown in FIGS. 14A and 14B, for example.

FIG. 14A shows a circuit schematic diagram of an RC integral operator unit in an embodiment of this disclosure. The RC integral operator unit includes one operational amplifier with a positive input terminal (+) coupled to one terminal of the resistor R and one terminal of the capacitor C, a negative input terminal (-) that can be coupled to a reference voltage, and an output terminal coupled to the other terminal of the capacitor C; and the other terminal of the resistor R (i.e., the left terminal in the diagram) can input of the output signal of the level shifter unit in the front stage.

FIG. 14B shows a circuit schematic diagram of a Gm-C integral operator unit in an embodiment of this disclosure. Gm is a transconductance amplifier with an output terminal coupled to one terminal of the capacitor C, the other terminal of the capacitor C being grounded. An input terminal of Gm can input of the output signal of the level shifter unit in the front stage.

The analog-to-digital converter unit is coupled to an output terminal of the integral operator unit for performing analog-to-digital conversion based on the operation result. In some embodiments, the analog-to-digital converter unit can include an analog-to-digital converter (ADC) for converting an analog signal into a digital signal.

In some examples, the output terminal of the analog-to-digital converter unit can be coupled to the controller module of the LiDAR, and the controller module can be implemented by a field-programmable gate array (FPGA), a system on chip (SoC), or other processing circuits.

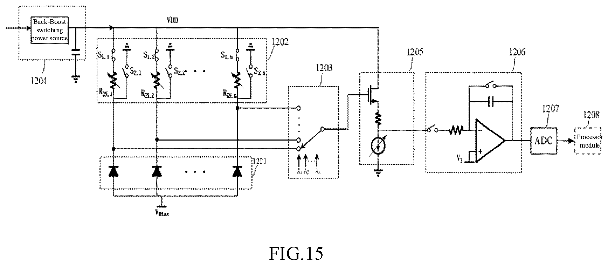

In FIG. 15, a structural schematic diagram of a light detection circuit in a specific embodiment of this disclosure is shown.

FIG. 15 is based on the circuit structure of FIG. 13 and provides the structures of an array of photodetector units 1201, an array of switches 1202, a selector unit 1203, a power supply regulator unit 1204, a level shifter unit 1205, an integral operator unit 1206, and an analog-to-digital converter unit 1207 and so on in possible specific embodiments. The operation result of the digital signal output by the analog-to-digital converter unit 1207 can be transmitted to a controller module 1208 for calculating, by the controller module 1208, optical energy information of the echo signal.

Specifically, the power supply regulator unit 1204 can be implemented by a Buck-Boost switching power source, and the array of switches 1202 and the array of photodetector units 1201 can be implemented as the example embodiments in association with FIG. 7A; the level shifter unit 1205 can be example shown in the form of FIG. 11, where the variable current source can also be implemented according to, for example, FIG. 12E; the integral operator unit 1206 is example implemented by an RC integral operator unit, and for example, one switch is connected in parallel at both terminals of the capacitor so as to select bypass capacitor, and one switch is connected in series in a connection line between the input terminal corresponding to one terminal of the resistor and the output terminal of the level shifter unit 1205 in the front stage so as to control ON/OFF between the integral operator unit 1206 and the front stage.

It can be understood that the specific structure of the light detection circuit shown in FIG. 15 is only an example and can be changed as needed, and is not intended to limit its implementation.

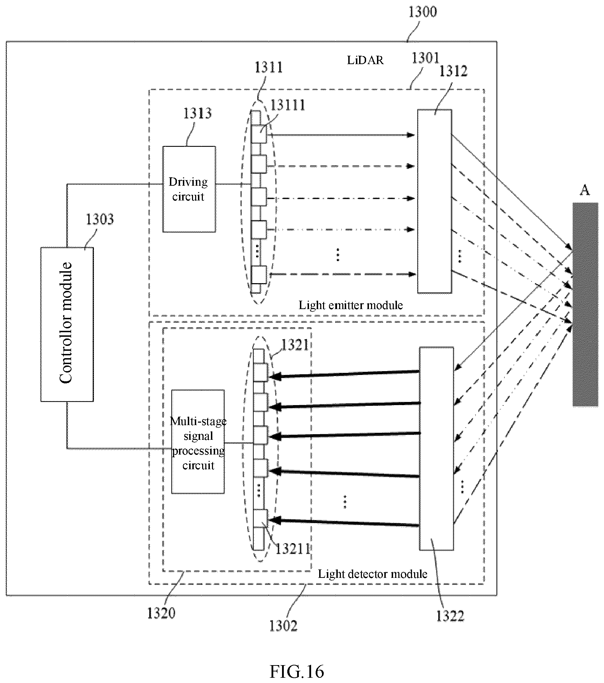

In FIG. 16, a structural schematic diagram of a LiDAR in an embodiment of this disclosure is shown.

In this example, a LiDAR 1300 includes a light emitter module 1301, a light detector module 1302, and a controller module 1303. Among others, the light emitter module 1301 includes an array of light emitter units 1311 including a plurality of light emitter units 13111. The light emitter unit 13111 can be implemented by at least one light emitter that can be a laser, such as a vertical cavity surface emitting laser (VCSEL) or an edge emitting laser (EEL).

The light emitter module 1301 can further include an emission lens 1312 and a driving circuit 1313 for the array of light emitter units 1311.

The light detector module 1302 includes a light detection circuit 1320. The light detection circuit 1320 can be implemented referring to the light detection circuit in the previous embodiments of FIG. 6, 8, 10, 13, or 15. The light detection circuit 1320 includes an array of photodetector units 1321 and a multi-stage signal processing circuit (including, e.g., an array of switches, a selector unit, a power supply voltage regulator unit 1, a level shifter unit, an integral operator unit, and an analog-to-digital converter unit, and further possibly with or not with a processor module) for reading an output signal of the array of photodetector units 1321. The array of photodetector units 1321 includes a plurality of photodetector units 13211 that can include at least one photodetector (e.g., SiPM or SPAD).

Each light emitter unit 13111 outputs an emitted signal that passes through the emission lens 1312 (for shaping/collimation, for example), is emitted from the LiDAR 1300, and is reflected to form an echo signal when encountering an obstacle A, the echo signal entering the LiDAR 1300, passing through a receiving lens 1322 (for shaping/convergence, for example) and being detected by each photodetector unit 13211 in the array of photodetector units 1321. In some embodiments, one light emitter unit 13111 and one photodetector unit 13211 form one detection channel, where an echo signal formed by reflection of an emitted signal of one light emitter unit 13111 is detected by one photodetector unit 13211. If there are N pairs of light emitter units 13111 and photodetector units 13211, there can be N detection channels formed, and each detection channel can correspond to different fields of view. Optionally, the fields of view among the detection channels can be overlapping or non-overlapping. Among others, the detection channel selected to operate is the aforesaid measurement channel, while other channels not selected to operate are the non-measurement channels.

The controller module 1303 is coupled with the light emitter module 1301 and the light detector module 1302, and is configured to transmit switch signals to the array of switches to set switch states of some of first switch units to drive photodetector units coupled to some of first switch units to activate to detect light signals; and to set switch states of the rest of first switch units to deactivate photodetector units coupled to the rest of first switch units. Specifically, the controller module can be implemented as FPGA, SoC, or other processing circuits. In the aforesaid embodiments, the processor module 308 or 1208 described in FIG. 13 or 15, for example, can be located in the controller module 1303, or integrated in the light detector module 1302 to be in communication connection with the controller module 1303.

In an embodiment of this disclosure, a light detection method can be further provided. The light detection method can be applied to the LiDAR in a previous embodiment to control the operation of the light detection circuit. Specifically, the method can be executed by the controller module in the LiDAR, or implemented through simulation of a design of the light detection circuit in EDA software.

The light detection method can include:
transmitting switch signals to an array of switches to set switch states of some of first switch units to drive photodetector units (belonging to a measurement channel) coupled to the some of first switch units to activate to detect light signals; and to set switch states of the rest of first switch units to deactivate photodetector units (belonging to non-measurement channels) coupled to the first switch units so as to be in a non-operating state.

In some embodiments, applying switch signals to some of first switch units in the array of switches to drive the coupled photodetector units to activate includes: applying switch signals to respective first switch units in a part of the array of switches one by one to drive respective photodetector units to activate correspondingly.

An example is taken to explain the aforesaid process of activating the photodetector units one by one. For example, in an array of photodetector units in a linear array or an area array, one or more photodetector units (which can correspond to one or more measurement channels) are activated together (which can be done at the same time) for detection during each detection, and one or more additional photodetector units (corresponding to one or more additional measurement channels) are further activated for detection next time, and so on, until all the photodetector units (every detection channel) have operated in turn, and the cycle is repeated.

Among others, a plurality of photodetector units that are activated together can be a column of photodetector units in the array of photodetector units, some of photodetector units in a column, a row of photodetector units, or some of photodetector units in a row, or the like. Alternatively, respective photodetector units on the array of photodetectors can also be grouped based on their closeness in spatial position, and the plurality of photodetector units that are activated together each time can also come from respective photodetector unit groups respectively. Each photodetector unit group can correspond to one channel, so that the plurality of photodetector units that belong to different channels but operate together are relatively away from one another in spatial position to reduce crosstalk among the channels.

In an embodiment of this disclosure, a computer-readable storage medium can be further provided, which stores program instructions that execute the light detection method when being run. That is, the steps of the aforesaid light detection method can be implemented as program instructions (e.g., software or computer codes) that can be stored in the readable storage medium (e.g., CD ROM, RAM, floppy disk, hard disk, or magneto-optical disk), or be implemented as program instructions that can be downloaded through the network and originally stored in a remote recording medium or a non-temporary machine-readable storage medium and will be stored in a local recording medium, so that the medium can be read by a general-purpose computer, a dedicated processor or programmable or dedicated hardware (such as SoC or FPGA) and the program instructions therein are run to implement the light detection method.

In summary, this disclosure provides a light detection circuit, a light detection method, a LiDAR, and a storage medium. Among others, the light detection circuit includes an array of photodetector units including a plurality of photodetector units for receiving light signals and generating corresponding electrical signals. An array of switches includes a plurality of first switch units, each first switch unit is correspondingly coupled to a photodetector unit, and each first switch unit can control an operating state of the coupled photodetector unit, such that a signal output terminal of the coupled photodetector unit outputs the electrical signal. And a selector unit can select a photodetector unit in the operating state to output the electrical signal. By setting the switch states of respective first switch units of the array of switches in the light detection circuit, photodetector units that are required to operate together can be selected to be activated to operate, and photodetector units that are not required to operate can be set in a state of being unable to be activated, which can prevent interference such as external ambient light, improve the detection accuracy of the LiDAR, and also prevent unnecessary energy consumption.

With regard to the problems existing in the existing technology about the manner of sampling echo pulse signals using a peak holding circuit and a medium to low-speed ADC, an embodiment of this disclosure provides a pulse signal peak detection system. On the basis of the structures of the peak holding and sampling circuit and ADC circuit, a multi-channel sampling and holding circuit is added to sample and store peak signals of a plurality of echo pulse signals respectively, and gate the stored peak signals one by one for sampling by the ADC.

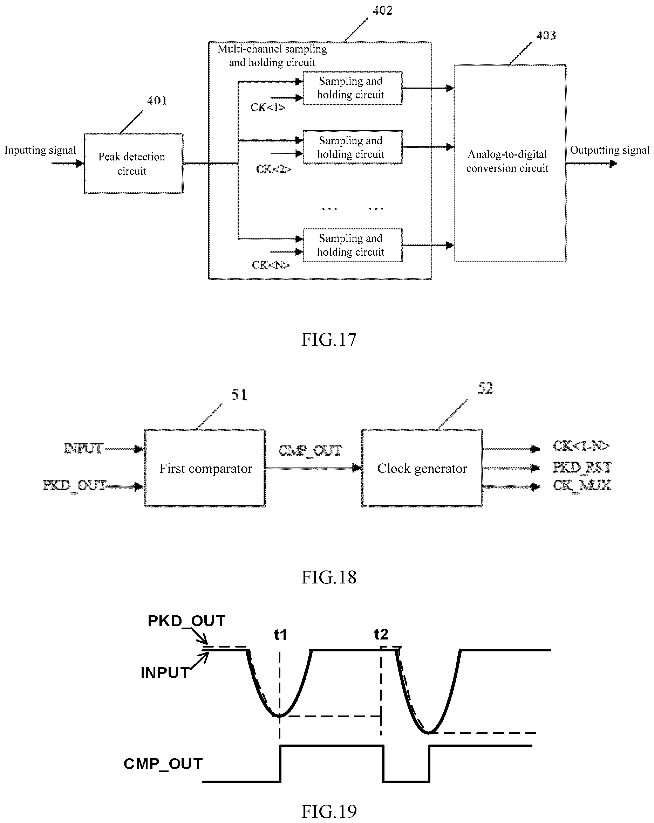

In FIG. 17, a structural block diagram of a pulse signal peak detection system in an embodiment of this disclosure is shown.

In this embodiment, the system includes a peak detection circuit 401, a multi-channel sampling and holding circuit 402, and an analog-to-digital conversion circuit 403, which are connected sequentially through signals. Among others:
the peak detection circuit 401 can receive a pulse signal to be detected, detecting peak signals of the pulse signal, and outputting the peak signals to the multi-channel sampling and holding circuit 402;
the multi-channel sampling and holding circuit 402 can sample and store respective peak signals of the pulse signal to be detected respectively;
the analog-to-digital conversion circuit 403 can sample respective peak signals stored in the multi-channel sampling and holding circuit one by one, and output sampled data corresponding to the pulse signal to be detected.

In practical disclosures, the multi-channel sampling and holding circuit 402 includes two or more sampling and holding circuits. The specific number of the multi-channel sampling and holding circuits can be set based on a pulse frequency range of the pulse signal to be detected and a conversion frequency of the analog-to-digital converter.

In the pulse signal peak detection system provided by the embodiment of this disclosure, with regard to the problems existing in the current process of sampling a high-speed pulse signal using a peak holding and sampling circuit and a medium to low-speed ADC, a multi-channel sampling and holding circuit is added on the basis of the structures of the peak holding and sampling circuit and ADC circuit. Respective sampling and holding circuits in the multi-channel sampling and holding circuit sequentially samples and stores peak signals of a plurality of echo pulse signals respectively; further, by gating the stored peak signals one by one for sampling by the ADC, it can also achieve sampling of respective peak signals even in the case that time intervals of a plurality of echo pulse signals in the pulse signal to be detected are relatively close, effectively improving the accuracy of echo pulse signal sampling.

A sampling time sequence of the multi-channel sampling and holding circuit 402 can be controlled by a first control signal CK<1-N>, that is, the first control signal CK<1-N> can control the multi-channel sampling and holding circuit 402 to sequentially sample and store respective peak signals in the pulse signal.

As shown in FIG. 18, the first control signal CK<1-N> can be generated by a first comparator 51 and a clock generator 52. Among others:
a pulse signal INPUT to be detected and an output signal PKD_OUT of the peak detection circuit 401 are input into two input terminals of the first comparator 51 respectively, to convert the pulse signal INPUT to be detected into a digital pulse signal and output the digital pulse signal to the clock generator 52.

It need be noted that the pulse signal to be detected can be a negative pulse signal or a positive pulse signal. The peak detection circuit 401 has a voltage following function, and correspondingly, the output signal PKD_OUT of the peak detection circuit 401 can also be a negative pulse signal or a positive pulse signal.

In the case that the output signal PKD_OUT of the peak detection circuit 401 is a negative pulse signal, when the pulse signal to be detected is greater than the output signal of the peak detection circuit, this indicates that the peak signal has been collected, and the clock generator outputs the first control signal; on the contrary, in the case that the output signal PKD_OUT of the peak detection circuit 401 is a positive pulse signal, when the pulse signal to be detected is smaller than the output signal of the peak detection circuit, the clock generator outputs the first control signal. The generation of the first control signal is further explained below by taking as an example the case that the output signal PKD_OUT of the peak detection circuit 401 is a negative pulse signal.

As shown in FIG. 19, taking the pulse signal INPUT to be detected being a negative pulse as an example, when t is smaller than t1, INPUT is smaller than PKD_OUT, and the first comparator 51 outputs a low level; at time t1, the peak detection circuit 401 detects a peak of the pulse signal INPUT to be detected, and holds this peak until time t2; therefore, when t is smaller than t2 and greater than t1, INPUT is greater than PKD_OUT, and the first comparator 51 outputs a high level. Among others, t1 is the pulse peak holding time in the output signal of the peak detection circuit 401, and t2 is the reset time of the peak detection circuit 401. At the time t2, the peak detection circuit 401 is reset and activates to redetect the next peak signal in the pulse signal INPUT to be detected.

The clock generator 52 generates the first control signal CK<1-N> based on a digital pulse signal CMP_OUT output by the first comparator 51.

Specifically, when the first comparator 51 detects that the peak of the input signal INPUT comes, namely, when the comparator outputs a high level, the clock generator 52 outputs the first control signal CK<1-N> to control the sampling and holding circuits 1-N to be turned on sequentially. Only one sampling and holding circuit is connected to the peak detection circuit 401 each time, where CK<1> corresponds to the first pulse peak in the pulse signal INPUT to be detected, for controlling connection between the first sampling and holding circuit and the peak detection circuit 401, so that the first sampling and holding circuit samples and stores the first pulse peak detected by the peak detection circuit 401; and CK<2> corresponds to the second pulse peak in the pulse signal INPUT to be detected, for controlling connection between the second sampling and holding circuit and the peak detection circuit 401, so that the second sampling and holding circuit samples and stores the second pulse peak detected by the peak detection circuit 401, and so on. The number of sampling and holding circuits is N, which is determined by the pulse frequencies of the input signals INPUT and the conversion frequency of the analog-to-digital conversion circuit 403.

In the pulse signal peak detection system of the embodiment of this disclosure, based on the output signal of the peak detection circuit, the first comparator and the clock generator can generate the first control signal to control a sampling time sequence of respective sampling and holding circuits in the multi-channel sampling and holding circuit, so that respective sampling and holding circuits sequentially sample and store the peak signals of a plurality of echo pulses respectively, which can better ensure the accuracy of the sampled signals. By gating the stored peak signals one by one for sampling by the ADC, it can also achieve sampling of respective peak signals even in the case that time intervals of a plurality of echo pulse signals in the pulse signal to be detected are relatively close, effectively improving the accuracy of echo pulse signal sampling.

Further, the clock generator 52 can further generate a second control signal PKD_RST for resetting the peak detection circuit 401 based on the digital pulse signal CMP_OUT output by the first comparator 51, that is to say, the second control signal PKD_ RST serves as a reset signal for the peak detection circuit 401. Specifically, after the multi-channel sampling and holding circuit 402 samples and stores respective peak signals in the pulse signal to be detected, the second control signal resets the peak detection circuit 401, so that the peak detection circuit 401 can redetect the next peak signal in the pulse signal to be detected.

The peak detection circuit 401 is controlled by the second control signal to reset, so that the peak detection circuit 401 can effectively detect a plurality of pulse signal peaks in the pulse signal to be detected.

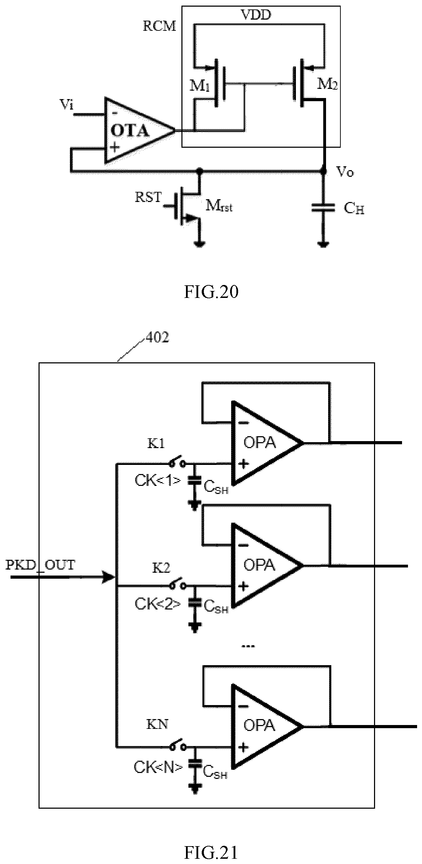

In a specific embodiment, the peak detection circuit 401 can be as shown in FIG. 20, including a transconductance operational amplifier OTA, a rectifier current mirror circuit RCM including MOS transistors M1 and M2, a capacitor CH, and a MOS transistor Mrst. In this example, the RCM can achieve unidirectional conduction, and the MOS transistor Mrst can be a switch. The operating process of this circuit is divided into three stages: reset, sampling, and holding.

During the reset stage, RST is high, the MOS transistor Mrst is ON, and the output voltage Vo is reset to zero.

During the sampling stage, RST is low, the MOS transistor Mrst is turned OFF, the transconductance amplifier OTA controls RCM to charge the capacitor CH when Vi is greater than Vo, where RCM is unidirectionally ON and only charges the capacitor CH, and Vo gradually increases; and the output voltage of the transconductance amplifier OTA approaches VDD when Vo is greater than Vi, and the charging current drops to 0.

After the capacitor CH samples a pulse peak, it enters into a holding state, and Vo does not change with Vi.

In a specific embodiment, as shown in FIG. 21, each sampling and holding circuit in the multi-channel sampling and holding circuit 402 includes a sampling switch K1, K2... KN, an operational amplifier OPA, and a capacitor CSH. The sampling switch is connected to the output terminal of the peak detection circuit 401 and a positive input terminal of the operational amplifier OPA, the capacitor CSH is connected to the positive input terminal of the operational amplifier OPA and the ground, and a negative input terminal of the operational amplifier OPA is connected to an output terminal of the operational amplifier OPA. The operational amplifier can avoid crosstalk among different channels can serve as a buffer.

Among others, the sampling switches K1, K2... KN are respectively controlled by the first control signal CK<1-N>. The capacitor CSH can store the pulse signal peak. For example, when CK<1> controls the switch K1 to be ON, PKD_ OUT is input to a sampling and holding circuit corresponding to CK<1>, PKD_ OUT charges the capacitor CSH therein, and finally the capacitor CSH stores a DC voltage in PKD_OUT, namely a pulse signal peak voltage. Based on the principles of virtual short and virtual break of an amplifier, the output terminal of the operational amplifier OPA outputs the pulse signal peak voltage stored in the capacitor CSH; and when CK<1> controls the switch K1 to be OFF, CSH discharges and waits for the next CK<1> gating.

In practical applications, the analog-to-digital conversion circuit 403 can be implemented in various ways, which will be explained below in detail through examples respectively.

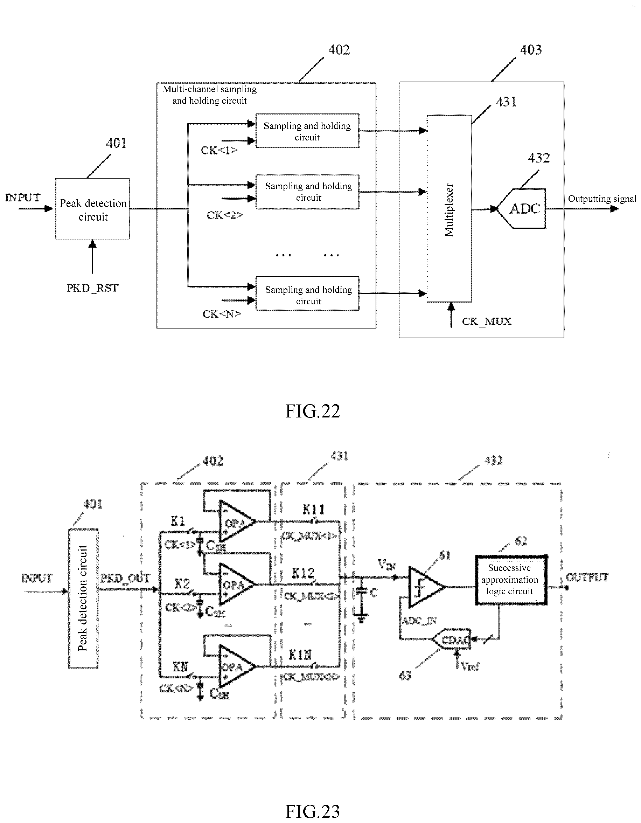

As shown in FIG. 22, it is a schematic diagram of a specific structure of an analog-to-digital conversion circuit in an embodiment of this disclosure.

In this embodiment, the analog-to-digital conversion circuit 403 includes a multiplexer 431 and an analog-to-digital converter 432 (i.e., ADC) connected to an output terminal of the multiplexer 431.

Among others, the multiplexer 431 can gate, based on a third control signal CK_MUX<1-N>, respective sampling and holding circuits in the multi-channel sampling and holding circuit 402 one by one for sampling by the analog-to-digital converter 432. Specifically, after the first control signal CK<1-N> controls one of the sampling and holding circuits in the multi-channel sampling and holding circuit 402 to carry out storage, the multiplexer 431 gates the one of the sampling and holding circuits based on the third control signal CK_MUX<1-N> to cause the analog-to-digital converter 432 to carry out sampling.

Referring to FIG. 18, the third control signal CK_MUX<1-N> for controlling the gating time sequence of the multiplexer 431 can also be generated by the clock generator 52 based on the digital pulse signal CMP_OUT output by the first comparator.

The multiplexer 431 can specifically include a plurality of control switches, each control switch is connected to an output terminal of a sampling and holding circuit and an input terminal of the analog-to-digital converter 432. Gating of respective control switches are controlled by the third control signal CK_MUX<1-N>.

Based on the analog-to-digital conversion circuit structure shown in FIG. 22, an embodiment of this disclosure provides a pulse signal peak detection system as shown in FIG. 23.

In this embodiment, the multi-channel sampling and holding circuit 402 includes sampling switches K1 to KN, capacitors CSH, and operational amplifiers. The multiplexer 431 includes N control switches K11 to K1N. Among others, the operational amplifier can avoid crosstalk among different channels and can serve as a buffer. The output voltage is the same as the input voltage, and can drive the analog-to-digital converter 432.

Referring to both FIGS. 18 and 23, in this embodiment, an input pulse signal INPUT is input to the peak detection circuit 401 and the first comparator 51 respectively. The peak detection circuit 401 outputs a peak of the input pulse signal INPUT, and peaks of N pulses are sequentially stored by N sampling and holding circuits 402, and input to the analog-to-digital converter 432 sequentially through the multiplexer 431 for sampling, and a digital signal corresponding to the pulse peaks is output.

In this embodiment, one of the sampling switches K1 to KN is controlled to be ON by the first control signal CK<1-N>, the capacitor CSH is charged, and a peak pulse voltage is stored after the charging is completed. When the control signal CK_MUX<1-N> controls the switch K11 of the control switches K11 to K1N corresponding to this line to be ON, the analog-to-digital converter 432 carries out peak sampling for the pulse signal.

It need be noted that in practical applications, the analog-to-digital converter 432 can use various types of analog-to-digital converters, such as a SAR (successive approximation register) type and a pipeline type, which is not limited by the embodiments of this disclosure.

The characteristic of an SAR type analog-to-digital converter is that the power loss changes with the sampling rate. Taking an SAR type analog-to-digital converter as an example, referring to FIG. 23, the analog-to-digital converter 432 can include: a second comparator 61, a successive approximation logic circuit 62, a capacitive analog-to-digital converter 63, and a capacitor C. Among others, one input terminal of the second comparator 61 is connected to the output terminal of the multiplexer 431, and the other input terminal of the second comparator 61 is connected to an output terminal of the capacitive digital to analog converter 63; an output terminal of the second comparator 61 is connected to an input terminal of the successive approximation logic circuit 62; an output terminal of the successive approximation logic circuit 62 outputs sampled data of the pulse signal to be detected, and outputs a feedback signal to the capacitive analog-to-digital converter 63. The capacitor C can store a peak of the pulse signal. For example, when CK_MUX<1> controls the control switch K11 to be ON, a sampling and holding circuit corresponding to CK<1> outputs a pulse signal peak voltage stored in the capacitor CSH to charge the capacitor C; and when CK_MUX<1> controls the control switch K11 to be OFF, the capacitor C discharges and waits until the next time the control signal CK_MUX controls one control switch in the multiplexer 431 to be ON. The operating principle of the analog-to-digital converter 432 is as follows: first taking and solving one initial estimated value, and gradually narrowing the error of the estimated value through a series of steps, which is typically achieved through iteration. In practical applications, the analog-to-digital converter 432 can hold a constant sampling time (e.g., per 20ns) or use different sampling times based on pulse signals, for example, setting different sampling times by using an asynchronous SAR type analog-to-digital converter.

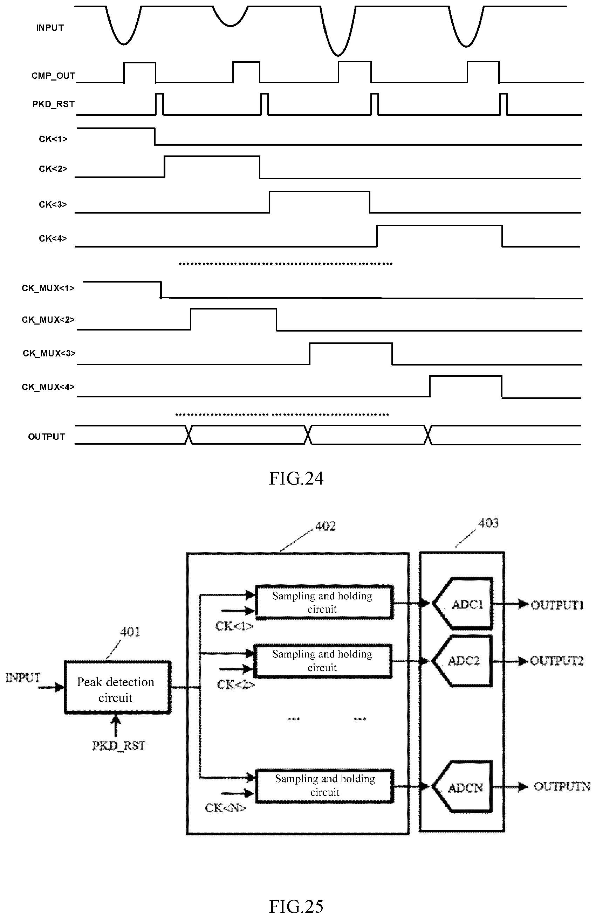

The time sequences of respective signals in the embodiment shown in FIG. 23 are shown in FIG. 24. The specific explanation is made as below by referring to both FIGS. 23 and 24:

When the first pulse arrives, CK<1> is at a high level, the sampling switch K1 is ON, and another CK<x> is at a low level, that is, only the first sampling and holding circuit is connected to the output of the peak detection circuit 401; and when the pulse reaches the peak, the first comparator output signal CMP_OUT changes from the low level to the high level, the capacitor CSH is charged, and the pulse peak is held.

When the first comparator output signal CMP_OUT changes from the high level to the low level, and the peak information of the first pulse has been stored by the first one sampling and holding circuit. At this time, the clock generator changes CK<1> from the high level to the low level, and the corresponding switch K1 changes from ON to OFF, and the capacitor CSH discharges; meanwhile, the control signal CK_MUX<1> of the multiplexer is held at the high level, the control switch K11 is held ON, and the analog-to-digital converter 432 performs peak sampling and outputs a digital signal OUTPUT. The clock generator generates one reset pulse (PKD_RST) of the peak detection circuit 401, which controls the reset of the peak detection circuit 401, and when PKD_RST is low, the reset of the peak detection circuit 401 is completed and CK_MUX<1> changes from the high level to the low level, and the corresponding switch K11 is OFF and waits for the next pulse to arrive.

Subsequently, when the second pulse arrives, CK<2> is at a high level, another CK<x> is at a low level, the second sampling and holding circuit is connected to the output of the peak detection circuit 401, and the above process is repeated. The multiplexer 432 controls the output VIN on the sampling and holding circuit 402 to be sequentially input into the analog-to-data converter 432 for conversion. After the analog-to-data converter 432 completes the conversion, CK_MUX controls the multiplexer 431 to switch to the next channel.

In the above process, after the first control signal CK<1-N> controls one of the sampling and holding circuits in the multi-channel sampling and holding circuit 402 to carry out storage, the multiplexer 431 gates the one of the sampling and holding circuits based on the third control signal CK_MUX<1-N> to cause the analog-to-digital converter 432 to carry out sampling. For example, in FIG. 24, MUX2 is gated at the rising edge of CK_MUX<2>; between the rising edges of CK<2> and CK<3>, that is, when CK<2> in the current line generates a rising edge, a sampling and holding circuit correspondingly controlled by CK<2> is caused to carry out peak sampling and storage; after the peak is stored, and before CK<3> in the next line generates a rising edge, that is, before a sampling and holding circuit correspondingly controlled by CK<3> caries out peak sampling and storage, the multiplexer 431 is caused to gate MUX2 in the current line, so that the analog-to-digital converter 432 samples the peak signal stored in the sampling and holding circuit correspondingly controlled by CK<2>.

As shown in FIG. 25, it is a schematic diagram of another specific structure of the analog-to-digital conversion circuit in the embodiment of this disclosure.

In this embodiment, the analog-to-digital conversion circuit 403 includes a plurality of analog-to-digital converters (ADCs), an input terminal of each analog-to-digital converter ADC is connected to an output terminal of one of the sampling and holding circuits in the multi-channel sampling and holding circuit.

In this embodiment, the analog-to-digital converter ADC can also use the SAR type analog-to-digital converter shown in FIG. 23.

In the pulse signal peak detection system provided by the embodiment of this disclosure, a multi-channel sampling and holding circuit is added on the basis of the structures of the peak holding and sampling circuit and ADC circuit. Respective sampling and holding circuits in the multi-channel sampling and holding circuit sequentially samples and stores peak signals of a plurality of echo pulse signals respectively; further, by gating the stored peak signals one by one for sampling by the ADC, it can also achieve sampling of respective peak signals even in the case that time intervals of a plurality of echo pulse signals in the pulse signal to be detected are relatively close, effectively improving the accuracy of echo pulse signal sampling.

Further, various ways can be employed to sample and output each of the peak signals stored in the multi-channel sampling and holding circuit, such as the structural form including a multiplexer and an analog-to-digital converter as shown in FIG. 22, that is, the multiplexer gating respective sampling and holding circuits in the multi-channel sampling protection circuit 402 one by one for sampling by the analog-to-digital converter 432; or the structural form including a plurality of analog-to-digital converters as shown in FIG. 25, that is, an input terminal of each analog-to-digital converter ADC being connected to an output terminal of one of the sampling and holding circuits in the multi-channel sampling and holding circuits 402 to convert the peak signal held in the sampling and holding circuit into a digital signal to be outputted. Providing different structural forms enriches the diversity of circuit structures and facilitates users to make different selections based on application needs. Based on the pulse signal peak detection system provided by the embodiment of this disclosure, accurate measurement of high-speed pulse signal peaks can be achieved using a medium to low-speed ADC (with a sampling rate of 1MHz, for example), that is, the medium to low-speed ADC can be used to replace a high-speed ADC typically required in the system. Compared to the solution of using a high-speed ADC to achieve pulse signal peak detection, the system of this disclosure can significantly reduce the cost and power consumption of the system.

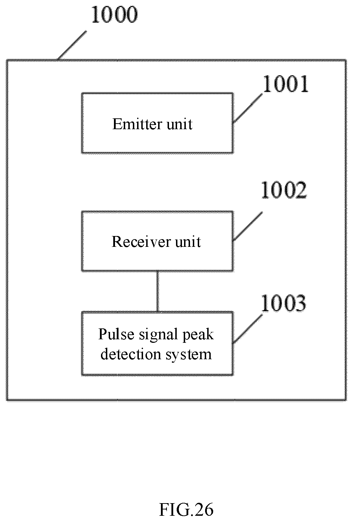

An embodiment of this disclosure further provides a LiDAR, as shown in FIG. 26, including: an emitter unit 1001, a receiver unit 1002, and a pulse signal peak detection system 1003 as described in each of the previous embodiments. Among others:
the emitter unit 1001 can emit a detection beam for detecting a target object;
the receiver unit 1002 can receive an echo beam of the detection beam reflected on the target object, and convert the echo beam into an echo pulse signal; and
the pulse signal peak detection system 1003 can sample the echo pulse signal and output a sampled signal.

In a non-limiting embodiment, the receiver unit 1002 can be a SiPM array including a plurality of SiPMs disposed apart from one another, which can form a plurality of columns of SiPMs, for example, and specifically can be arranged in a matrix or staggered manner.

The LiDAR based on the pulse signal peak detection system in the embodiment of this disclosure still can achieve effective sampling of respective peak signals even in the case that the time intervals of a plurality of echo pulse signals in the pulse signal are relatively close, effectively improving the accuracy of echo pulse signal sampling by the LiDAR. Since the pulse signal peak detection system can use a medium to low-speed ADC to sample the pulse signal, it can effectively reduce the hardware cost of the LiDAR.

In the specific implementation, various modules/units contained in various devices and products described in the aforesaid embodiments can be a software module/unit, a hardware module/unit, or partially a software module/unit and partially a hardware module/unit.

For example, regarding various devices and products applied to or integrated into a chip, various modules/units contained therein all can be implemented by using hardware such as circuits, or at least some modules/units can be implemented by using software programs that run on the processor integrated within the chip, while the remaining modules/units (if any) can be implemented by using hardware such as circuits; regarding various devices and products applied to or integrated into a chip module, various modules/units contained therein all can be implemented by using hardware such as circuits, and different modules/units can be located in the same component (e.g., chip, and circuit module) or different components of the chip module, or at least some modules/units can be implemented by using software programs that runs on the processor integrated within the chip module, while the remaining modules/units (if any) can be implemented by using hardware such as circuits; regarding various devices and products applied to or integrated into a terminal, various modules/units contained therein all can be implemented by using hardware such as circuits, and different modules/units can be located in the same component (e.g., chip, and circuit module) or different components within the terminal, or at least some modules/units can be implemented by using software programs that run on the processor integrated within the terminal, while the remaining modules/units (if any) can be implemented by using hardware such as circuits.

It should be understood that the term "and/or" used herein is only a description of the association relationship between associated objects, indicating that there can be three types of relationships. For example, A and/or B can represent three cases where A exists alone, A and B exist simultaneously, and B exists alone. Additionally, the mark "/" used herein indicates that the associated objects are in an "or" relationship.

The term "plurality of" in the embodiments of this disclosure refers to two or more.

Description with first, second, or the like. in the embodiments of this disclosure is only for the purposes of illustrating and distinguishing the described objects, which neither implies their order, nor represents a special limitation of the number of apparatuses in the embodiments of this disclosure, and thus cannot constitute any restriction on the embodiments of this disclosure.

The term "connect" in the embodiments of this disclosure refers to various connection manners such as direct or indirect connection to achieve communication between apparatuses, which is not limited in the embodiments of this disclosure.

The aforesaid embodiments are only illustrative explanations of the principles and efficacy of this disclosure, and are not intended to limit this disclosure. Anyone familiar with this technology can modify or change the aforesaid embodiments without going against the spirit and scope of this disclosure. Therefore, all equivalent modifications or changes made by those with ordinary knowledge in the relevant technical field without departing from the spirit and technical ideas disclosed in this disclosure should still be covered by the claims of this disclosure.

## Claims

1. A light detection circuit for a LiDAR, comprising:
an array of photodetector units comprising a plurality of photodetector units for receiving light signals and generating corresponding electrical signals;
an array of switches comprising a plurality of first switch units, each first switch unit being correspondingly coupled to a photodetector unit, and each first switch unit being configured to control an operating state of the coupled photodetector unit, such that a signal output terminal of the coupled photodetector unit outputs the electrical signals; and
a selector unit, configured to select the photodetector unit in the operating state to output the electrical signals.

2. The light detection circuit of claim 1, comprising: a first power supply terminal coupled to a power supply source;
the first switch unit comprising:
a first switching element with one terminal coupled to the first power supply terminal, and another terminal coupled to one terminal of a photodetector unit; the one terminal of the photodetector unit coupled to the first switching element being a signal output terminal;
wherein a switch state of the first switching element corresponds to ON/OFF of a path between the first power supply terminal and the signal output terminal.

3. The light detection circuit of claim 2, wherein each of the first switch units further comprises:
a second switching element with one terminal coupled to the one terminal of the photodetector unit coupled to the first switching element, and another terminal coupled to a ground terminal;
wherein a switch state of the second switching element corresponds to ON/OFF of a path between the signal output terminal and the ground terminal.

4. The light detection circuit of claim 3, wherein switch states of the first switching element and the second switching element are set to be opposite.

5. The light detection circuit of claim 1, comprising a power supply regulator unit with an output terminal connected to the first power supply terminal to provide a variable power supply.

6. The light detection circuit of claim 5, wherein the power supply source is regulated to output a plurality of voltage values; and the a plurality of voltage values are respectively adapted to photodetector units with different operating voltages.

7. The light detection circuit of claim 5, comprising a level shifter unit with an input terminal coupled to an output terminal of the selector unit, and configured to convert a voltage output by the selector unit to a predetermined voltage range.

8. The light detection circuit of claim 7, wherein the level shifter unit comprises at least one second switch unit, a first impedance unit, and a current source;
each second switch unit comprises a first terminal coupled to the first power supply terminal, a second terminal coupled to one terminal of the first impedance unit, and a control terminal coupled to the output terminal of the selector unit; and the control terminal is configured to control ON-OFF of the first terminal and the second terminal; and
another terminal of the first impedance unit is coupled to one terminal of the current source, and another terminal of the current source is coupled to the ground terminal.

9. The light detection circuit of claim 8, wherein the current source comprises:
a first current mirror circuit comprising a first branch and a second branch respectively led out by at least one pair of common-gate transistors with a gate coupled to a control terminal of the current source; a second impedance unit being connected in series in the first branch; one terminal of each of the first branch and the second branch being coupled to a second power supply terminal, and another terminal of the first branch being grounded through the second impedance unit; and voltages connected to the second power supply terminal and the first power supply terminal being different; and
a second current mirror circuit comprising a third branch and a fourth branch respectively led out by at least one pair of common-gate transistors; one terminal of the third branch being coupled in series to another terminal of the second branch, and another terminal of the third branch being coupled to a ground terminal; one terminal of the fourth branch being coupled to one terminal of the first impedance unit, and another terminal of the fourth branch being grounded, such that a ratio value between currents flowing through the first impedance unit and the second impedance unit is regulatable.

10. The light detection circuit of claim 9, wherein the fourth branch comprises N sub-branches in parallel, with N greater than or equal to 2, a transistor being connected in series in each sub-branch, wherein the transistor of each sub-branch is selectable to be connected to or disconnected from a transistor in the third branch, to regulate the ratio value between the currents flowing through the first impedance unit and the second impedance unit.

11. The light detection circuit of claim 8, wherein the current source comprises:
a first current mirror circuit comprising at least one first PMOS and at least one second PMOS connected through a common gate and a common source, the gate being coupled to a control terminal of the current source, and the source being connected to the second power supply terminal; a drain of the first PMOS being coupled to a ground terminal through a second impedance unit; wherein voltages connected to the second power supply terminal and the first power supply terminal are different; and
a second current mirror circuit comprising: a first NMOS with a gate and a drain that are coupled to a drain of the second PMOS, and a source coupled to the ground terminal; and at least one second NMOS connected with the first NMOS through a common gate, and with a drain coupled to one terminal of the first impedance unit and a source coupled to the ground terminal.

12. The light detection circuit of claim 11, wherein there are N second NMOSs, with N greater than or equal to 2; a drain of each second MOS is coupled to one another and coupled to one terminal of the first impedance unit, and a source coupled to the ground terminal; and a gate of each second NMOS is coupled to the gate of the first NMOS through a third switching element, and coupled to the ground terminal through a fourth switching element.

13. The light detection circuit of claim 9 or 11, wherein the current source further comprises:
an operational amplifier comprising:
a negative input terminal connected to a reference voltage;
a positive input terminal coupled to one terminal of the second impedance unit to provide the reference voltage; and
an output terminal used as the control terminal of the current source.

14. The light detection circuit of claim 8, wherein the second switch unit comprises a third NMOS; and the control terminal, the first terminal, and the second terminal of the second switch unit are respectively led out by a gate, a drain, and a source of the third NMOS.

15. The light detection circuit of claim 8, wherein the first impedance unit comprises one of the following: a variable resistor or a plurality of transistors connected in series.

16. The light detection circuit of claim 8, wherein there is a plurality of second switch units connected in parallel.

17. The light detection circuit of claim 7, comprising:
an integral operator unit coupled to the output terminal of the level shifter unit for performing an integral operation of a received electrical signal to obtain an operation result; and
an analog-to-digital converter unit coupled to an output terminal of the integral operator unit for performing analog-to-digital conversion based on the operation result.

18. The light detection circuit of claim 1, wherein the first switch unit further comprises a variable impedance unit connected in series between a first switching element and a photodetector unit.

19. The light detection circuit of claim 1, comprising: a first power supply terminal coupled to a power supply source; the first switch unit further comprising:
a trans-impedance amplifier unit comprising: a first input terminal coupled with the first switching element to the first power supply terminal, and coupled with the second switching element to a ground terminal; a second input terminal coupled to one terminal of a photodetector unit, and coupled to an output terminal of the trans-impedance amplifier unit through a third impedance unit; and the output terminal coupled to the signal output terminal.

20. A light detection method, for controlling the light detection circuit of any one of claims 1 to 19, the light detection method comprising:
transmitting switch signals to an array of switches to set switch states of some of first switch units to drive photodetector units coupled to the some of the first switch units to activate to detect light signals; and to set switch states of a rest of the first switch units to deactivate photodetector units coupled to the rest of the first switch units.

21. The light detection method of claim 20, wherein the applying the switch signals to the some of the first switch units in the array of switches to drive the coupled photodetector units to activate comprises:
applying the switch signals to respective first switch units in a part of the array of switches one by one to drive respective photodetector units to activate correspondingly.

22. A LiDAR comprising:
a light emitter module comprising an array of light emitter units configured to output an emitted signal;
a light detector module comprising a light detection circuit of any one of claims 1 to 19; wherein an array of photodetector units is configured to receive an echo signal reflected after the emitted signal collides with an obstacle; and
a controller module coupled with the light emitter module and the light detector module, and configured to transmit switch signals to an array of switches to set switch states of some of first switch units to drive photodetector units coupled to the some of the first switch units to activate to detect light signals; and to set switch states of a rest of first switch units to deactivate photodetector units coupled to the rest of first switch units.

23. A computer-readable storage medium storing program instructions that, when being run, execute the light detection method of claim 20 or 21.

24. A pulse signal peak detection system, wherein the system comprises:
a peak detection circuit for receiving a pulse signal to be detected, detecting peak signals of the pulse signal, and outputting the peak signals to a multi-channel sampling and holding circuit;
the multi-channel sampling and holding circuit for sampling and storing respective peak signals of the pulse signal to be detected respectively; and
an analog-to-digital conversion circuit for sampling respective peak signals stored in the multi-channel sampling and holding circuit one by one, and outputting sampled data corresponding to the pulse signal to be detected.

25. The system of claim 24, wherein a number of multi-channel sampling and holding circuits is set based on a pulse frequency of the pulse signal to be detected and a conversion frequency of the analog-to-digital converter.

26. The system of claim 24, wherein the system further comprises a first comparator and a clock generator,
two input terminals of the first comparator are respectively driven by a pulse signal to be detected and an output signal of the peak detection circuit, to convert the pulse signal to be detected into a digital pulse signal and output the digital pulse signal to the clock generator; and
the clock generator generating a first control signal based on the digital pulse signal output by the first comparator; and the first control signal being configured to control a sampling sequence of the multi-channel sampling and holding circuit.

27. The system of claim 26, wherein when the pulse signal to be detected is a negative pulse signal, and when the pulse signal to be detected is greater than the output signal of the peak detection circuit, the clock generator outputs the first control signal; and the first control signal is configured to control the multi-channel sampling and holding circuit to sample and store each peak signal in the pulse signal to be detected.

28. The system of claim 26, wherein when the pulse signal to be detected is a positive pulse signal, and when the pulse signal to be detected is smaller than the output signal of the peak detection circuit, the clock generator outputs the first control signal; and the first control signal is configured to control the multi-channel sampling and holding circuit to sample and store each peak signal in the pulse signal to be detected.

29. The system of claim 26, wherein the clock generator is further configured to generate a second control signal based on the digital pulse signal output by the first comparator, the second control signal is a reset signal for the peak detection circuit.

30. The system of claim 29, wherein after the multi-channel sampling and holding circuit samples and stores one of peak signals in the pulses signal to be detected, the second control signal resets the peak detection circuit, such that the peak detection circuit redetects a next peak signal in the pulse signal to be detected.

31. The system of claim 26, wherein each sampling and holding circuit in the multi-channel sampling and holding circuit comprises a sampling switch, an operational amplifier, and a capacitor, the sampling switch being connected to an output terminal of the peak detection circuit and a positive input terminal of the operational amplifier, the capacitor being connected to the positive input terminal of the operational amplifier and the ground, a negative input terminal of the operational amplifier being connected to an output terminal of the operational amplifier, and the sampling switch being controlled by the first control signal.

32. The system of claim 26, wherein the clock generator further generates a third control signal based on the digital pulse signal output by the first comparator; and the analog-to-digital conversion circuit comprises a multiplexer and an analog-to-digital converter connected to an output terminal of the multiplexer; and
the multiplexer gates, based on the third control signal, respective sampling and holding circuits in the multi-channel sampling and holding circuit one by one for sampling by the analog-to-digital converter.

33. The system of claim 32, wherein after the first control signal controls one of the sampling and holding circuits in the multi-channel sampling and holding circuit to store, the multiplexer gates the one of the sampling and holding circuits based on the third control signal to drive the analog-to-digital converter to sample.

34. The system of claim 32, wherein the multiplexer comprises a plurality of control switches, each control switch being connected to an output terminal of one sampling and holding circuit and an input terminal of the analog-to-digital converter.

35. The system of claim 24, wherein the analog-to-digital conversion circuit comprises a plurality of analog-to-digital converters, an input terminal of each analog-to-digital converter connected to an output terminal of one sampling and holding circuits in the multi-channel sampling and holding circuit.

36. The system of claim 32 or 35, wherein the analog-to-digital converter comprises a second comparator, a logic circuit, and a digital to analog converter,
one input termina of the second comparator connected to an output terminal of the multiplexer, another input terminal connected to an output terminal of the digital to analog converter, and an output terminal of the second comparator connected to an input terminal of the logic circuit; and
an output terminal of the logic circuit outputting sampled data of the pulse signal to be detected, and outputting a feedback signal to the digital to analog converter.

37. A LiDAR, comprising an emitter unit, a receiver unit, and the pulse signal peak detection system of any one of claims 24 to 36,
the emitter unit being configured to emit a detection beam for detecting a target object;
the receiver unit being configured to receive an echo beam of the detection beam reflected on the target object, and convert the echo beam into an echo pulse signal; and
the pulse signal peak detection system being configured to sample the echo pulse signal and output the sampled signal.
